# EUROPEAN PATENT APPLICATION

(11) **EP 4 506 645 A1**
(43) Date of publication of application: **12.02.2025**
(21) Application number: 23802965.6
(22) Date of filing: 10.05.2023
(51) Int. Cl.: F27B 14/00, F27B 17/00, C30B 23/00, C30B 29/36

(54) **CRYSTAL GROWTH DEVICE**

(30) Priority: 12.05.2022 CN 202210511620; 27.05.2022 CN 202210584487
(71) Applicant: MEISHAN BOYA ADVANCED MATERIALS CO., LTD., Meishan, Sichuan 620010 (CN)
(72) Inventor: WANG, Yu, Meishan, Sichuan 620010 (CN); LEI, Pei, Meishan, Sichuan 620010 (CN); FU, Jun, Meishan, Sichuan 620010 (CN)
(74) Representative: Wang, Bo
(86) International application number: PCT/CN2023/093337
(87) International publication number: WO 2023/217196

(57) **Abstract**

Embodiments of the present disclosure provide a crystal growth device including: a crucible including a raw material cavity for placing a raw material and a growth cavity for crystal growth; and at least one insulation device disposed on at least one side surface outside the crucible.

## Description

### TECHNICAL FIELD

The present disclosure relates to the field of crystal growth technology, and in particular, to a crystal growth device.

### BACKGROUND

When performing a crystal (e.g., a semiconductor crystal) growth using a physical vapor transport (PVT), a crucible needs to be heated, and an insulating layer needs to be disposed on an outside of the crucible. A seed crystal is disposed on an inside of an upper cover of the crucible, and the crystal is grown on the seed crystal.

### SUMMARY

One or more embodiments of the present disclosure provide a crystal growth device including: a crucible including a raw material cavity for placing raw material and a growth cavity for crystal growth; and at least one insulation device disposed on at least one side surface outside the crucible.

In some embodiments, the crucible includes an upper cover including a cover body and a seed crystal tray. The seed crystal tray is detachably connected to the cover body.

In some embodiments, the seed crystal tray includes a connecting structure disposed in a center region of a side of the seed crystal tray close to the cover body.

In some embodiments, a thickness of the seed crystal tray is in a range of 2 mm-10 mm.

In some embodiments, two surfaces of the seed crystal tray that are in contact with the cover body include a concave structure and a convex structure that cooperate with each other.

In some embodiments, the seed crystal tray includes a separation groove for separating seed crystals on the seed crystal tray.

In some embodiments, the separation groove is a circumferential groove disposed at a periphery of a side of the seed crystal tray away from the cover body.

In some embodiments, a ratio of a depth of the circumferential groove along a radial direction to a radius of the seed crystal tray is in a range of 0.028-0.042.

In some embodiments, a depth of the circumferential groove along a radial direction is in a range of 2 mm-4 mm, and a height of the circumferential groove along an axial direction is in a range of 0.5 mm-1.5 mm.

In some embodiments, the crucible includes a guiding device disposed between the raw material cavity and the growth cavity, the guiding device including a first guiding surface inclined toward a bottom surface of the raw material cavity.

In some embodiments, the guiding device includes a guiding groove, the guiding groove being a concave groove disposed at an outer periphery of the guiding device.

In some embodiments, the guiding groove includes a second guiding surface parallel or substantially parallel to the first guiding surface, and a guiding wall is formed between the first guiding surface and the second guiding surface.

In some embodiments, the guiding device further includes a support wall which is radially connected to the guiding wall and to an outer peripheral wall of the crucible.

In some embodiments, a thickness of the guiding wall is in a range of 10 mm-60 mm.

In some embodiments, a height of the guiding groove is in a range of 20 mm-40 mm.

In some embodiments, a ratio of a thickness of the guiding wall to a height of the guiding groove is in a range of 0.2-1.5.

In some embodiments, a thickness of the support wall is in a range of 10 mm-60 mm.

In some embodiments, a ratio of a thickness of the guiding wall to a thickness of the support wall is in a range of 0.8-1.2.

In some embodiments, the crystal growth device further includes a furnace cavity and a temperature measurement structure. The crucible is disposed in the furnace cavity, the temperature measurement structure includes a temperature measurement cavity and a temperature measurement window, the temperature measurement cavity includes a first cavity section, a main body portion, and a second cavity section, the temperature measurement window is disposed in the first cavity section, and the second cavity section is connected to the furnace cavity.

In some embodiments, a diameter of the main body portion is less than a diameter of the furnace cavity.

In some embodiments, a diameter of the first cavity section or a diameter of the second cavity section is less than a diameter of the main body portion.

In some embodiments, the temperature measurement structure further includes an air inlet and an air outlet, the air inlet being interconnected with the first cavity section, and the air outlet being interconnected with the second cavity section.

In some embodiments, a diameter of the air outlet is less than a diameter of the air inlet.

In some embodiments, the temperature measurement structure further includes a cooler disposed in the second cavity section.

In some embodiments, the temperature measurement structure further includes a deposition cavity connected to the furnace cavity.

In some embodiments, a temperature within the deposition cavity is lower than a temperature within the furnace cavity.

In some embodiments, the temperature measurement structure further includes a deposition cavity connected to the second cavity section.

In some embodiments, a temperature within the deposition cavity is lower than both a temperature within the furnace cavity and a temperature within the temperature measurement cavity, and a pressure within the deposition cavity is lower than a pressure within the temperature measurement cavity.

In some embodiments, the at least one insulation device includes a first insulation assembly, and the first insulation assembly includes: an inner layer with a thickness that satisfies a preset condition; an outer layer. A material of the outer layer is different from a material of the inner layer; and a middle layer disposed between the inner layer and the outer layer.

In some embodiments, the first insulation assembly is at least disposed on a circumferential side of the crucible.

In some embodiments, the thickness of the inner layer is in a range of 4 mm-57 mm.

In some embodiments, a thickness of the middle layer is in a range of 28 mm-143 mm.

In some embodiments, a thickness of the middle layer is greater than both the thickness of the inner layer and a thickness of the outer layer.

In some embodiments, a ratio of the thickness of the inner layer to a thickness of the middle layer is in a range of 1:2-1:10.

In some embodiments, a ratio of a thickness of the middle layer to a thickness of the outer layer is in a range of 2:0.5-10:3.

In some embodiments, a ratio of the thickness of the inner layer to a thickness of the outer layer is in a range of 1:0.5-1:3.

In some embodiments, the inner layer includes at least two insulation sections stacked top and down.

In some embodiments, the inner layer varies in the thickness along an axial direction.

In some embodiments, the material of the inner layer includes a graphite felt.

In some embodiments, the material of the outer layer includes at least one of zirconia, alumina, a carbon material, or a carbon fiber material.

In some embodiments, graphite paper is filled between the middle layer and the outer layer.

In some embodiments, the insulation device further includes a second insulation assembly disposed on a top of the crystal growth device.

In some embodiments, the second insulation assembly includes a laminated structure with a same material.

In some embodiments, the insulation device further includes a third insulation assembly, the third insulation assembly including an annular structure or a circular structure.

In some embodiments, an inner diameter of the annular structure is in a range of 10 mm-90 mm.

In some embodiments, a ratio of an outer diameter of the annular structure to a radius of the crucible is in a range of 0.6-1.2.

In some embodiments, a ratio of an inner diameter of the annular structure to an outer diameter of the annular structure is in a range of 0.1-0.8.

In some embodiments, a ratio of an inner diameter of the annular structure to a radius of the crucible is in a range of 0.1-0.9.

### BRIEF DESCRIPTION OF THE DRAWINGS

The present disclosure is further illustrated in terms of exemplary embodiments. These exemplary embodiments are described in detail with reference to the drawings. These embodiments are not limiting, and in these embodiments, the same numbering denotes the same structure, wherein
FIG. 1 is a schematic diagram illustrating a structure of a crystal growth device according to some embodiments of the present disclosure;
FIG. 2 is a schematic diagram of the structure illustrating an upper cover according to some embodiments of the present disclosure;
FIG. 3 is a schematic diagram illustrating a structure of a crystal growth device according to some embodiments of the present disclosure;
FIG. 4 is a partially enlarged schematic diagram illustrating a seed crystal tray shown in FIG. 2;
FIG. 5 is a schematic illustration illustrating a structure of an upper cover according to some embodiments of the present disclosure;
FIG. 6 is a schematic diagram illustrating a structure of a seed crystal tray according to some embodiments of the present disclosure;
FIG. 7 is a schematic diagram illustrating a structure of a crystal growth device according to some embodiments of the present disclosure;
FIG. 8 is a schematic diagram illustrating a structure of a guiding device according to some embodiments of the present disclosure;
FIG. 9A is a schematic diagram illustrating a cross-section of a crystal growth device according to some embodiments of the present disclosure;
FIG. 9B is a schematic diagram illustrating a structure of a crystal growth device according to some embodiments of the present disclosure;
FIG. 10 is a schematic diagram illustrating a structure of a temperature measurement structure according to some embodiments of the disclosure;
FIG. 11 is a schematic diagram illustrating a structure of a temperature measurement structure according to some embodiments of the present disclosure;
FIG. 12 is a schematic diagram illustrating a structure of a temperature measurement structure according to some embodiments of the present disclosure;
FIG. 13 is a schematic diagram illustrating a structure of a temperature measurement structure according to some embodiments of the present disclosure;
FIG. 14 is a schematic diagram illustrating a structure of a temperature measurement structure according to some embodiments of the present disclosure;
FIG. 15 is a schematic diagram illustrating a structure of a temperature measurement structure according to some embodiments of the present disclosure;
FIG. 16 is a schematic diagram illustrating a structure of a crystal growth device according to some embodiments of the present disclosure;
FIG. 17A is a schematic diagram illustrating a structure of an inner layer of a first insulation assembly according to some embodiments of the present disclosure;
FIG. 17B is a schematic diagram illustrating a structure of an insulation section according to some embodiments of the present disclosure;
FIG. 17C is a schematic diagram illustrating a structure of an inner layer of a first insulation assembly according to some embodiments of the present disclosure;
FIG. 17D is a schematic diagram illustrating a structure of an inner layer of a first insulation assembly according to some embodiments of the present disclosure;
FIG. 18 is a schematic diagram of a structure of a first insulation assembly according to some embodiments of the present disclosure;
FIG. 19 is a schematic diagram illustrating a structure of a first insulation assembly according to some embodiments of the present disclosure;
FIG. 20 is a schematic diagram illustrating a structure of a crystal growth device according to some embodiments of the present disclosure; and
FIG. 21 is a schematic diagram illustrating a structure of a crystal growth device according to some embodiments of the present disclosure.

### DETAILED DESCRIPTION

To clearly illustrate the technical solutions of the embodiments of the present disclosure, the accompanying drawings required to be used in the description of the embodiments are briefly described below. Obviously, the accompanying drawings in the following description are only some examples or embodiments of the present disclosure, and it is possible for those skilled in the art to apply the present disclosure to other similar scenarios based on the accompanying drawings without creative labor. Unless obviously obtained from the context or the context illustrates otherwise, the same numeral in the drawings refers to the same structure or operation.

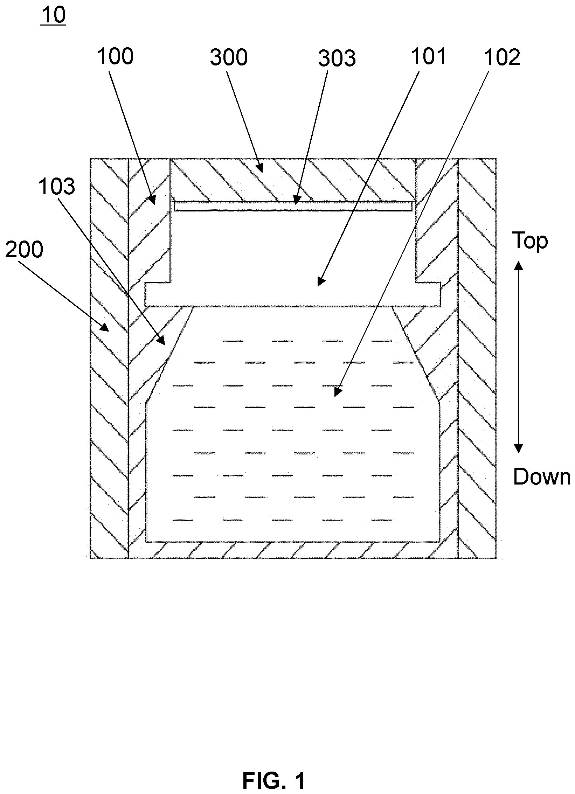

FIG. 1 is a schematic diagram illustrating a structure of a crystal growth device according to some embodiments of the present disclosure. The crystal growth device is described in detail in the following combining FIG. 1. In some embodiments, a crystal growth device 10 prepares crystals (e.g., semiconductor crystals such as silicon carbide crystals, aluminum nitride crystals, zinc oxide crystals, zinc antimonide crystals, etc.) based on physical vapor transport (PVT). In some embodiments, as shown in FIG. 1, the crystal growth device 10 includes a crucible 100, a heating assembly (not shown in FIG. 1), and at least one insulation device 200. The at least one insulation device 200 is disposed on at least one side surface out of the crucible 100.

The crucible 100 is configured as a container for holding materials required for crystal growth and is configured to grow crystals at a high temperature. In some embodiments, the crucible 100 includes a raw material cavity 102 for placing a raw material and a growth cavity 101 for the crystal growth. In some embodiments, the raw material cavity 102 is disposed below the growth cavity 101, and the raw material cavity 102 is connected to the growth cavity 101.

In some embodiments, the raw material cavity 102 is configured to store raw materials such as silicon carbide, aluminum nitride, zinc oxide, zinc antimonide, etc. The raw materials are sublimated into a vapor component under a high temperature (e.g., in the case of the preparation of silicon carbide crystals, the vapor component includes Si₂C, SiC₂, and Si).

In some embodiments, seed crystals 303 are disposed within the growth cavity 101, and crystals are generated by crystallization of the vapor component contacting the seed crystals within the growth cavity 101. In some embodiments, the seed crystals 303 are fixedly adhered to an inner side surface (e.g., a center of the inner side surface) of a top (e.g., an upper cover) of the crucible 100.

The heating assembly is disposed outside (e.g., surrounding) the crucible 100 for heating the crucible 100. An axial temperature gradient may be formed between the raw material and the seed crystals 303 during a crystal growth process by controlling heating parameters of the heating assembly. The raw material is decomposed and sublimated into the vapor components by heat (for example, when preparing silicon carbide crystals, the vapor components may include Si₂C, SiC₂, and Si). The vapor components are transported from a surface of the raw material to a surface of the seed crystals 303 under a driving effect of the axial temperature gradient. The vapor components crystallize on the surface of the seed crystals 303 to generate the crystals due to a relatively low temperature at the seed crystals 303. In some embodiments, the heating assembly includes an induction heating assembly, a resistance heating assembly, etc.

The insulation device 200 may reduce a heat exchange between an interior of the crucible 100 and an exterior of the crucible 100, thereby maintaining a stable temperature inside the crucible 100. In some embodiments, the insulation device 200 adopts a single-layer structure or a multi-layer structure. In some embodiments, the insulation device 200 is fully covered on a sidewall or a bottom of the crucible 100. More descriptions of the insulation device 200 may be found elsewhere in the present disclosure.

In some embodiments, in the case of preparing the silicon carbide crystals, a silicon carbide raw material is loaded into the raw material cavity 102. The seed crystals 303 are loaded into the growth cavity 101, with the seed crystals 303 facing downward. The crucible 100 is heated using the heating assembly to sublimate the silicon carbide within the raw material cavity 102 to produce vapor components. The vapor components rise up into the growth cavity 101 to contact the seed crystals 303 and generate the crystals by crystallizing on the surface of the seed crystals 303. The insulation device 200 is disposed on the exterior of the crucible 100 to insulate the crucible 100, so as to maintain the temperature inside the crucible 100 within a temperature range required for growing the crystals.

Various parts of the crystal growth device 10 and detailed structures thereof are described below.

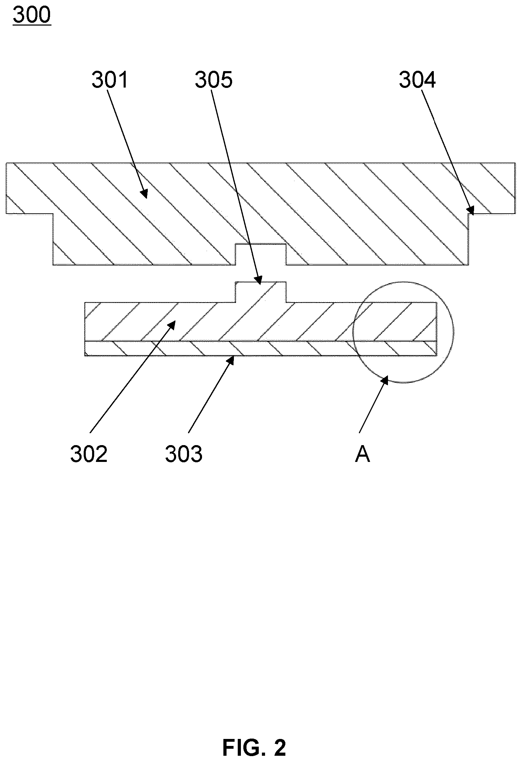

FIG. 2 is a schematic diagram of the structure illustrating an upper cover according to some embodiments of the present disclosure. The upper cover is described in detail below in conjunction with FIG. 2. As shown in FIG. 1 and FIG. 2, the crucible 100 includes an upper cover 300. In some embodiments, the crucible 100 has an opening at a top of the crucible 100, and the upper cover 300 is disposed at an opening of the crucible 100. The upper cover 300 includes a cover body 301 and a seed crystal tray 302. In some embodiments, the cover body 301 and the seed crystal tray 302 are removably connected.

The upper cover 300 is connected to the opening of the crucible 100 to close the opening to allow vapor components to gather predominantly within the growth cavity. In some embodiments, the upper cover 300 is adapted to fit a shape of the opening. In some embodiments, the upper cover 300 is a disk-shaped structure.

The cover body 301 is a structure in the upper cover 300 primarily configured to close the opening. The cover body 301 is also used as a mounting base for mounting the seed crystal tray 302, with the upper cover 300 connected to the opening of the crucible 100 through the cover body 301.

The seed crystal tray 302 is configured to carry and fix the seed crystals 303. In some embodiments, the seed crystals 303 are adhered to a lower surface of the seed crystal tray 302. The seed crystal tray 302 is disposed on the lower surface of the upper cover 300. With the upper cover 300 in place, the seed crystals 303 are disposed within the growth cavity 101.

In some embodiments, the seed crystal tray 302 is removably connected to the cover body 301. During the crystal growth, the seed crystal tray 302 is mounted on the cover body 301. After completing the crystal growth, the seed crystal tray 302 is removed from the cover body 301. When the crystals are required to be removed, the seed crystal tray 302 is destroyed or the seed crystal tray 302 undergoes a special processing, while the cover body 301 may be used continuously, which is conducive to reducing a production cost.

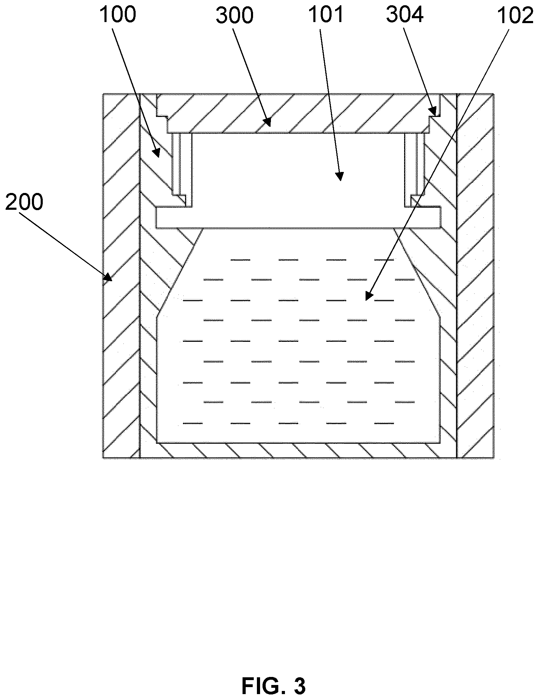

FIG. 3 is a schematic diagram illustrating a structure of a crystal growth device according to some embodiments of the present disclosure. The cover body is further described below in conjunction with FIG. 3. As shown in FIG. 2 and FIG. 3, in some embodiments, the cover body 301 is provided with a first step surface 304, and an opening of the crucible 100 is provided with a second step surface. The first step surface 304 and the second step surface are cooperatively mounted. In some embodiments, the first step surface 304 is disposed on a circumferential side of the cover body 301.

In some embodiments, there is a seam between the first step surface 304 and the second step surface. The seam enables an air exchange inside and outside of the crucible 100 and avoids an excessive air pressure inside the crucible 100.

In some embodiments, the first step surface 304 is disposed with tiny convex structures, and when the first step surface 304 is mounted in cooperation with the second step surface, the convex structures are configured to adjust a size of the seam formed between the first step surface 304 and the second step surface.

In some embodiments, the seed crystal stray 302 includes a connecting structure 305, as shown in FIG. 2. The connecting structure 305 and the seed crystals 303 are disposed on opposite sides of the seed crystal tray 302.

In some embodiments, the seed crystal tray 302 is removably connected to the cover body 301 through the connecting structure 305. In some embodiments, the connecting structure 305 includes one of a snap structure and a threaded connection structure. In some embodiments, the connecting structure 305 includes a screw with an external thread, and the cover body 301 is provided with an inner threaded hole connected to the external thread. In some embodiments, the connecting structure 305 includes a threaded hole with an internal thread, and the cover body 301 is provided with a screw connected to the threaded hole. In some embodiments, the connecting structure 305 is a slider, and the cover body 301 is provided with a groove connected to the slider. In some embodiments, the slider is a T-shaped slider, and the groove is a T-shaped groove.

In some embodiments, the connecting structure 305 is disposed in a center region of the seed crystal tray 302 near a side of the cover body 301. In some embodiments, a geometric center of the seed crystal tray 302 coincides with a center of gravity, and the center region may be a region where the geometric center of the seed crystal tray 302 is located. For example, the center region is a circular region centered on the geometric center of the seed crystal tray 302 with a radius within a preset range.

By disposing a removable seed crystal tray 302, the seed crystal tray 302 is separated from the cover body 301 after the crystal growth is completed, and a crystal pickup operation is then performed only on the seed crystal tray 302 without having to damage the cover body 301, so that the cover body 301 is able to be reused.

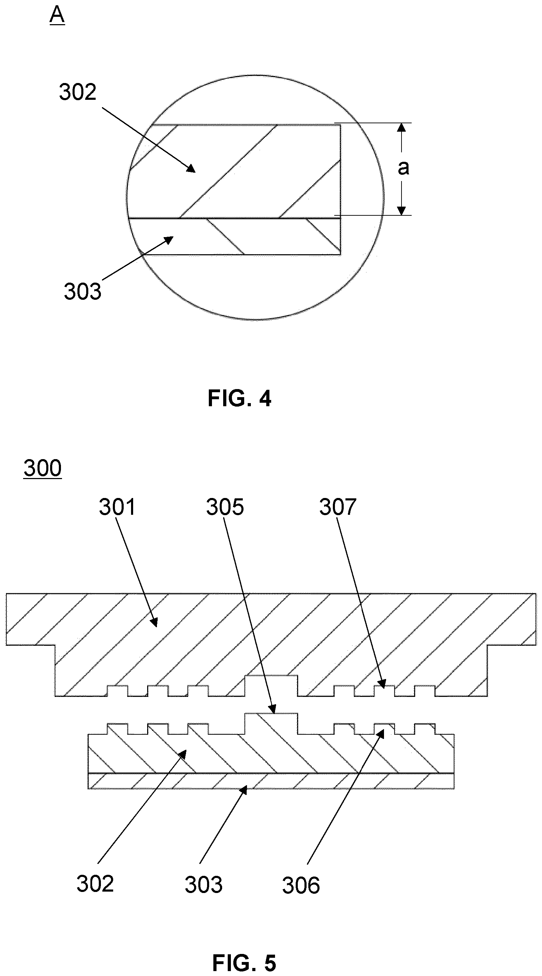

FIG. 4 is a partially enlarged schematic diagram illustrating a seed crystal tray shown in FIG. 2. The following is a detailed description of the seed crystal tray in conjunction with FIG. 4.

In some embodiments, when crystal growth is completed, in a process of crystal pickup, the seed crystal tray 302 is polished, and the crystals are picked up after consuming the material of the seed crystal tray 302. In this manner of crystal pickup, a mechanical stress brought in the process of crystal pickup is effectively reduced, so as to avoid damage to the crystals. In some embodiments, a thickness of the seed crystal tray 302 affects an efficiency and a reliability of the crystal pickup operation, and the less the thickness of the seed crystal tray 302, the higher the efficiency of the crystal pickup operation. However, the thickness of the seed crystal tray 302 should not be too small so as not to affect a structural strength of the seed crystal tray 302.

In some embodiments, the thickness a of the seed crystal tray is in a range of 2 mm-10 mm. In some embodiments, the thickness a of the seed crystal tray is in a range of 3 mm-9 mm. In some embodiments, the thickness a of the seed crystal tray is in a range of 4 mm-8 mm.

FIG. 5 is a schematic illustration illustrating a structure of an upper cover according to some embodiments of the present disclosure. The upper cover is described in detail below in conjunction with FIG. 5. As shown in FIG. 5, two surfaces of the seed crystal tray 302 that are in contact with the cover body 301 include a concave structure and a convex structure that cooperate with each other. When the seed crystal tray 302 is connected to the cover body 301, the cooperating concave structure and convex structures are utilized to increase a contact area and a connection strength between the seed crystal tray 302 and the cover body 301, which is conducive for the seed crystal tray 302 to transfer heat to the cover body 301.

In some embodiments, the convex structure and the concave structure include a convex structure 306 disposed on the seed crystal tray 302 and a concave structure 307 disposed on the cover body 301, and the convex structure 306 and the concave structure 307 are cooperatively mounted.

In other embodiments, the convex structure 306 is disposed on the cover body 301, and the concave structure 307 is disposed on the seed crystal tray 302.

In some embodiments, the convex structure 306 and the concave structure 307 are capable of fitting together on three sides. In some embodiments, there are a plurality of convex structures 306, the convex structures 306 are disposed parallel to each other, and a plurality of concave structures 307 are disposed in one-to-one correspondence with the convex structures 306. In some embodiments, a cross-section (which is parallel to an axis direction of the crucible 100) of the convex structure 306 may be one of a rectangle, a triangle, a semicircle, or a semi-ellipse, and a cross-section of the concave structure 307 is disposed in correspondence with the convex structure 306. In some embodiments, a specific structural shape of the connecting structure 305 is set according to a manner in which the seed crystal tray 302 and the cover body 301 are connected. In some embodiments, the seed crystal tray 302 is detachably connected to the cover body 301 by snapping, and the connecting structure 305 is a slider. The cover body 301 is disposed with a groove connected to the slider, and the cover body 301 and the seed crystal tray 302 may slide relative to each other through the cooperation between the slider and the groove. In some embodiments, the seed crystal tray 302 and the cover body 301 are removably connected by snapping or a threaded connection. The convex structure 306 may be a ring shaped protrusion, and a plurality of protrusions may be coaxially disposed. The concave structures 307 may be a ring shaped groove, and the plurality of concave structures 307 are disposed in one-to-one correspondence with the plurality of convex structures 306.

In some embodiments, the seed crystal tray 302 includes a separation groove 308. The separation groove 308 is a structure that facilitates crystal pickup. The seed crystals 303 on the seed crystal tray 302 are separated more easily by disposing the separation groove 308. In some embodiments, the separation groove 308 is disposed in different structural forms according to different ways of crystal pickup.

In some embodiments, the separation groove 308 includes a frangible structure that facilitates a destruction of the seed crystal tray 302. By pre-disposing the frangible structure on the seed crystal tray 302, the seed crystal tray 302 is destroyed during the crystal pickup, so as to reduce a seed crystal tray material adhered to the seed crystals 303 and facilitate the crystal pickup by grinding, etc. In some embodiments, the separation groove 308 is disposed on a side surface of a circumferential direction of the seed crystal tray 302. The separation groove 308 is a concave groove structure or a cracked structure that concaves inwardly from the side surface of the circumferential direction of the seed crystal tray 302. By applying an action force near the separation groove 308, the seed crystal tray 302 easily cracks at the separation groove 308 to be more easily destroyed, thereby facilitating the crystal pickup from the seed crystal tray 302.

In some embodiments, there are a plurality of the separation grooves 308 (e.g., frangible structures) disposed along the circumferential direction of the seed crystal tray 302, and the plurality of separation grooves 308 are equally or unequally spaced. In some embodiments, the plurality of separation grooves 308 are also disposed as an annular frangible structure (also referred to as a frangible band) around the circumferential direction of the seed crystal tray 302.

In some embodiments, the cross-sections of the separation grooves 308 are rectangular, triangular, or semi-circular.

In some embodiments, the separation grooves 308 include an auxiliary separation structure that facilitates separation of the seed crystals 303 from the seed crystal tray 302. In some embodiments, the auxiliary separation structure is disposed in a region near a connecting surface between the seed crystal tray 302 and the seed crystals 303. As the seed crystals 303 are adhered to the seed crystal tray 302, when picking up the crystals, an adhesive separation liquid is infiltrated into an adhesive surface between the seed crystal tray 302 and the seed crystals 303 by the auxiliary separation structure, so as to facilitate the separation of the seed crystal tray 302 and the seed crystals 303.

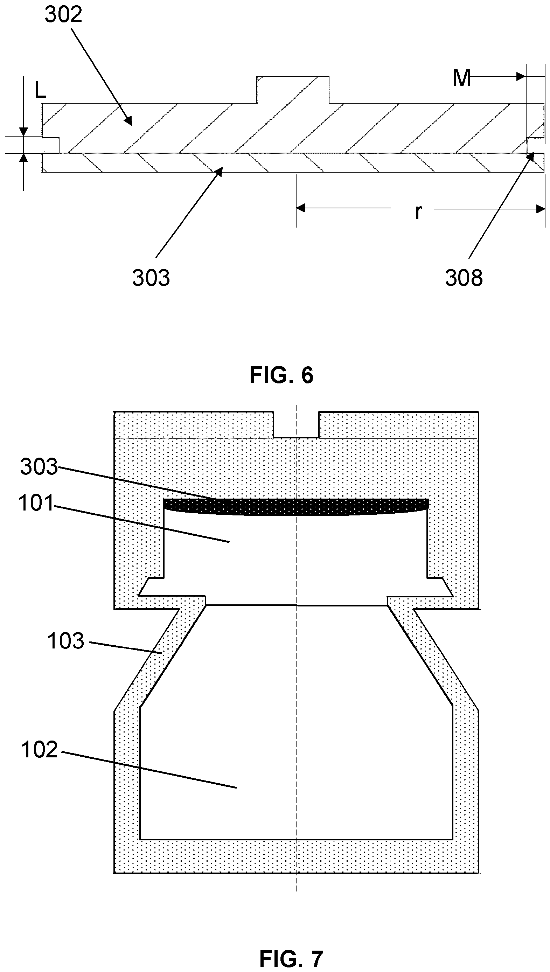

FIG. 6 is a schematic diagram illustrating a structure of a seed crystal tray according to some embodiments of the present disclosure. The separation groove is described in detail below in conjunction with FIG. 6. As shown in FIG. 6, the separation groove 308 is a circumferential groove (i.e., an auxiliary separation structure), and the circumferential groove is disposed on a periphery of a side of the seed crystal tray 302 that is away from the cover body 301.

In some embodiments, the circumferential groove is disposed in an edge region of a bottom surface of the seed crystal tray 302 (i.e., a surface connected to the seed crystals). In some embodiments, the circumferential groove is in a shape of a concave table that is recessed toward the cover body 301. By disposing the circumferential groove, a contact area between the seed crystal tray 302 and the seed crystals 303 is reduced, and a space that accommodates an adhesive separation liquid after the seed crystals 303 are adhered to the seed crystal tray 302 is reserved, so that the adhesive separation liquid can directly infiltrate a connecting surface between the seed crystal tray 302 and the seed crystals 303, thereby facilitating a disruption of the adhesive connection between the seed crystal tray 302 and the seed crystals 303 and making it easier to separate the seed crystals.

In some embodiments, a depth M of the circumferential groove affects an infiltration effect of the adhesive separation liquid on the connecting surface between the seed crystal tray 302 and the seed crystals 303. If the depth M is too small, it is difficult for the adhesive separation liquid to be maintained in the circumferential groove for a long period of time, and the adhesive separation liquid easily flows out of the circumferential groove, which diminishes the infiltration effect of the adhesive separation liquid on the connecting surface between the seed crystal tray 302 and the seed crystals 303. If the depth M is too large, the contact area between the seed crystal tray 302 and the seed crystals 303 is excessively reduced, and a connection strength between the seed crystal tray 302 and the seed crystals 303 is reduced, thereby decreasing a connection stability of the seed crystals 303. If the contact area is excessively small, heat transfer between the seed crystal tray 302 and the seed crystals 303 is affected, and an efficiency of the heat transfer at the edge of the seed crystals 303 to the seed crystal tray 302 is reduced, resulting in an uneven distribution of a temperature of the seed crystals 303, which affects a growth of the seed crystals. To ensure the infiltration effect of the circumferential groove, the depth M is set within a reasonable range. In some embodiments, a ratio of the depth M of the circumferential groove along a radial direction to a radius of the seed crystal tray is in a range of 0.02-0.05. In some embodiments, the ratio of the depth M of the circumferential groove along the radial direction to the radius of the seed crystal tray is in a range of 0.028-0.042. In some embodiments, the ratio of the depth M of the circumferential groove along the radial direction to the radius of the seed crystal tray is in a range of 0.03-0.04.

To further ensure the infiltration effect of the circumferential grooves, a height L of the circumferential groove along the axial direction may be set within a reasonable range. In some embodiments, the depth M of the circumferential groove along the radial direction is in a range of 2 mm-4 mm, and the height L of the circumferential groove along the axial direction is in a range of 0.5 mm-1.5 mm as shown in FIG. 6. In some embodiments, the depth M of the circumferential groove along the radial direction is in a range of 2.5 mm-3.5 mm and the height L of the circumferential groove along the axial direction is in a range of 0.8 mm-1.2 mm.

FIG. 7 is a schematic diagram illustrating a structure of a crystal growth device according to some embodiments of the present disclosure.

In some embodiments, referring FIG. 1 and FIG. 7, the crucible includes a guiding device 103 disposed between a raw material cavity and a growth cavity.

The guiding device 103 is a device that controls a direction of gas inside or outside the crucible. In some embodiments, the guiding device 103 is disposed between the raw material cavity and the growth cavity. In some embodiments, the guiding device 103 is disposed in the raw material cavity. In some embodiments, the guiding device 103 includes a guiding channel 104 connecting the raw material cavity 102 and the growth cavity 101. In some embodiments, an inlet of the guiding device 103 faces the raw material cavity, a closure of the guiding device 103 faces the growth cavity 101, and a size (e.g., a diameter) of the closure is smaller than a size of the inlet, i.e., the size of an end (i.e., the inlet) of the guiding channel 104 near the raw material cavity 102 is greater than the size of the an end (i.e., the closure) near the growth cavity 101. In some embodiments, the size (e.g., the diameter) of the end of the guiding channel 104 near the growth cavity 101 is smaller than a size of the raw material cavity 102. In some embodiments, a shape of the guiding device 103 is a hollow cone. In some embodiments, the shape of the guiding device 103 is a variety of other shapes, including, but not limited to, a hollow arc table, etc.

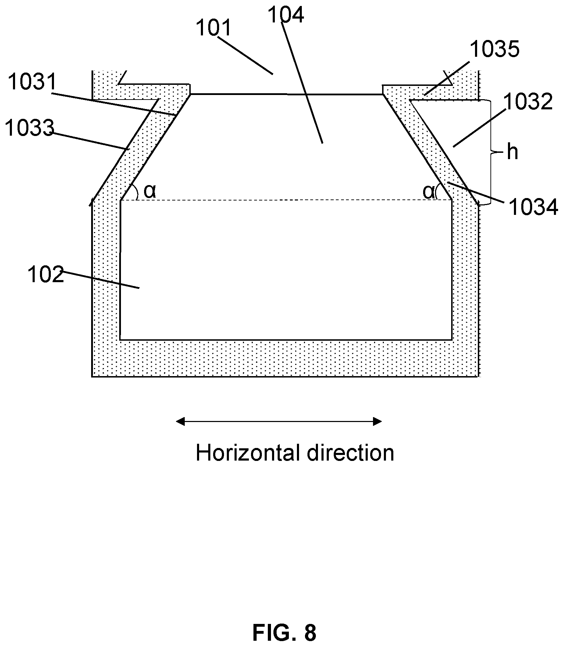

FIG. 8 is a schematic diagram illustrating an exemplary structure of a guiding device of a crystal growth device according to some embodiments of the present disclosure.

In some embodiments, the guiding device 103 includes a first guiding surface 1031 inclined toward a bottom surface of the raw material cavity 102. The first guiding surface 1031 is disposed on an outer wall of the raw material cavity and is disposed below the growth cavity 101. For example, as shown in FIG. 8, a bottom of the first guiding surface 1031 is connected to an inner sidewall of the raw material cavity 102, and a top of the first guiding surface 1031 extends obliquely toward the growth cavity 101.

As an edge region of seed crystals is closer to a heating assembly, a temperature at the edge region is usually slightly higher than a temperature in a center region. By setting the guiding device 103 with the first guiding surface 1031, vapor components flowing from the raw material cavity 102 to the growth cavity 101 may converge toward the center region, so as to increase the temperature in the center region of the growth cavity 101 and a concentration of the vapor component, thereby reducing a difference between a center temperature and an edge temperature of the seed crystal, and improving a quality of the crystal growth.

In some embodiments, by setting an inclining angle α (i.e., the angle between the first guiding surface 1031 and a horizontal direction) of the first guiding surface 1031, the flow direction of the high-temperature gas flow from the raw material cavity to the growth cavity can be changed to adjust the temperature distribution in the crystal growth region (e.g., at the seed crystals) in the growth cavity and the distribution of the vapor components in the growth cavity. A smaller inclining angle α facilitates a convergence of a high temperature airflow to the center of the crystal growth region, thereby reducing a temperature gradient between the center region and the edge region, facilitating an even growth of the crystals. But the inclining angle α should not be set too small, a too small inclining angle α leads to an excessive convergence of the vapor component to the center, which is not conducive to the crystal growth. Thereby, in some embodiments, the inclining angle α of the first guiding surface is in a range of 20°-80°. In some embodiments, the inclining angle α of the first guiding surface is in a range of 30°-70°. In some embodiments, the inclining angle α of the first guiding surface is in a range of 40°-60°.

In some embodiments, a radius of the closure of the guiding device 103 is set to achieve an effect of reducing the temperature gradient between the center and the edges as described above. In some embodiments, the radius of the closure of the guiding device 103 is in a range of 50 mm-110 mm. In some embodiments, the radius of the closure of the guiding device 103 is in a range of 55 mm-100 mm. In some embodiments, the radius of the closure of the guiding device 103 is in a range of 60 mm-90 mm.

In some embodiments, the guiding device 103 includes a guiding groove 1032. The guiding groove 1032 is a groove disposed at an outer periphery of the guiding device 103. As a size (e.g., a diameter) of an end of the guiding channel 104 that is near the growth cavity is smaller than a size of the raw material cavity, a thickness along a radial direction of the end of the conduction device 103 that is near the growth cavity is larger, and the larger thickness affects a heat conductivity of the conduction device 103 to a certain extent. As a result, the thickness of the guiding device 103 is reduced by disposing the guiding groove, which makes the thickness of the guiding device 103 more even, and improves the heat conductivity of the guiding device 103.

The guiding groove 1032 is disposed on the outer periphery of the guiding device 103 and on an outer wall of the crucible, and is located below the growth cavity 101. For example, as shown in FIG. 8, an guiding groove 1032 that inwardly concaves is disposed surrounding the outer wall of the crucible that is disposed in an upper region of the raw material cavity 102. In some embodiments, the guiding groove 1032 is shaped as a conical annular groove. In some embodiments, the guiding groove 1032 is in a variety of other shapes, including, but not limited to, an arc annular groove, etc.

In some embodiments, the guiding groove 1032 includes a second guiding surface 1033 that is parallel or substantially parallel to the first groove surface 1031. The "substantially parallel" as used in the embodiments of the present disclosure refers to that a minimum angle between two planes or lines that are referenced to each other does not exceed 10°.

In some embodiments, the second guiding surface 1033 faces an outer side of the crucible 100 and is located below the growth cavity 101. In some embodiments, a bottom of the second guiding surface 1033 is disposed on the outer wall of the crucible 100, and the top of the second guiding surface 1033 extends toward the growth cavity 101, as shown in FIG. 8.

In some embodiments, a guiding wall 1034 is formed between the first guiding surface 1031 and the second guiding surface 1033.

The guiding wall 1034 is a crucible wall between the first guiding surface 1031 and the second guiding surface 1033 that are outside of the raw material cavity 102. For example, as shown in FIG. 8, the inner side surface of the guiding wall 1034 is the first guiding surface 1031, the outer side surface of the guiding wall 1034 is the second guiding surface 1033, and a distance between the first guiding surface 1031 and the second guiding surface 1033 is a thickness of the guiding wall 1034. It should be noted that when the first guiding surface 1031 and the second guiding surface 1033 are not in parallel, the thickness of the guiding wall is an average distance between the first guiding surface 1031 and the second guiding surface 1033, which is an average value of a maximum distance and a minimum distance.

By disposing the thickness of the guiding wall 1034, the heat conductivity of the guiding device 103 is changed to affect a distribution of a temperature field inside the crucible 100. In some embodiments, the thickness of the guiding wall 1034 can be set within a certain thickness range by considering the temperature field distribution inside the crucible 100. In some embodiments, the thickness of the guiding wall 1034 is in a range of 10 mm-60 mm. In some embodiments, the thickness of the guiding wall 1034 is in a range of 10 mm-40 mm. In some embodiments, the thickness of the guiding wall 1034 is in a range of 10 mm-30 mm.

In some embodiments, as shown in FIG. 8, the guiding device 103 further includes a support wall 1035. The support wall 1035 is radially connected to the guiding wall 1034 and an outer peripheral wall of the growth cavity 101. In some embodiments, the support wall 1035 is disposed in a horizontal direction. In some embodiments, there is an angle between the support wall 1035 and the horizontal direction. In some embodiments, the angle between the support wall 1035 and the horizontal direction is no greater than 30°.

By disposing the thickness of the support wall 1035, the heat conductivity of the guiding device 103 toward the growth cavity 101 is changed to affect the temperature field distribution inside the growth cavity 101. In some embodiments, considering the temperature field distribution inside the growth cavity 101, the thickness of the support wall 1035 is set within a certain thickness range. The thickness of the support wall 1035 is represented by a distance between an inner side surface (a side surface facing the growth cavity 101) and an outer side surface (a side surface facing the guiding channel 1032) of the support wall 1035.

In some embodiments, the thickness of the support wall 1035 is in a range of 10 mm-60 mm. In some embodiments, the thickness of the support wall 1035 is in a range of 15 mm-50 mm. In some embodiments, the thickness of the support wall 1035 is in a range of 20 mm-40 mm.

In some embodiments, when the thickness of the support wall 1035 is determined, the thickness and a length of the guiding wall 1034 change at the same time by setting a height h of the guiding groove 1032, so as to change the heat conductivity of the guiding device 103, and thus affect the temperature field distribution inside the crucible 100. In some embodiments, the height h of the guiding groove 1032 is in a range of 20 mm-40 mm. In some embodiments, the height h of the guiding groove 1032 is in a range of 22 mm-38 mm. In some embodiments, the height h of the guiding groove 1032 is in a range of 25 mm-35 mm.

In some embodiments, a ratio of the thickness of the guiding wall 1034 to the height h of the guiding groove 1032 indicates a degree of inclination (e.g., an inclination angle) of the first guiding surface 1031 and the second guiding surface 1033, which further affect a flow situation of the vapor components within the guiding groove 104, and thus affects the temperature field distribution in the growth cavity 101. In some embodiments, considering the temperature field distribution inside the growth cavity 101, a ratio of the thickness of the guiding wall 1034 to the height h of the guiding groove 1032 is set within a certain range. In some embodiments, the ratio of the thickness of the guiding wall 1034 to the height h of the guiding groove 1032 is in a range of 0.2-1.5. In some embodiments, the ratio of the thickness of the guiding wall 1034 to the height h of the guiding groove 1032 is in a range of 0.5-1. In some embodiments, the ratio of the thickness of the guiding wall 1034 to the height h of the guiding groove 1032 is in a range of 0.2-0.8.

As the thickness of the support wall 1035 primarily affects an ability of the guiding device 103 to conduct heat towards the edge region of the growth cavity 101, thereby primarily affecting the temperature at the edge of the crystal growth; the thickness of the guiding wall 1034 primarily affects the ability of the guiding device 103 to conduct heat toward a closure region, thereby primarily affecting the temperature of a center region of the growth cavity 101. In some embodiments, a ratio of the thickness of the guiding wall 1034 to the thickness of the support wall 1035 is set within a certain range to make a difference between a center temperature and an edge temperature of the crystal growth smaller.

In some embodiments, the ratio of the thickness of the guiding wall 1034 to the thickness of the support wall 1035 is in a range of 0.8-1.2. In some embodiments, the ratio of the thickness of the guiding wall 1034 to the thickness of the support wall 1035 is in a range of 0.6-1.5. In some embodiments, the ratio of the thickness of the guiding wall 1034 to the thickness of the support wall 1035 is in a range of 0.9-1.

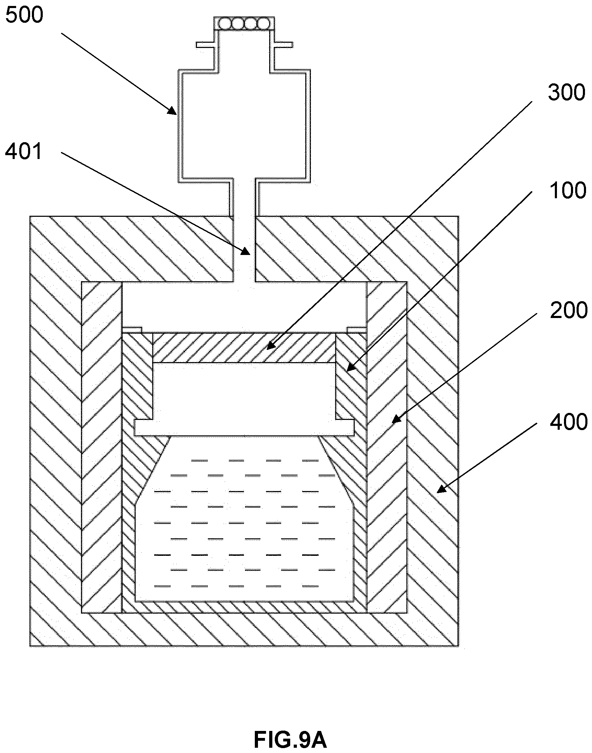

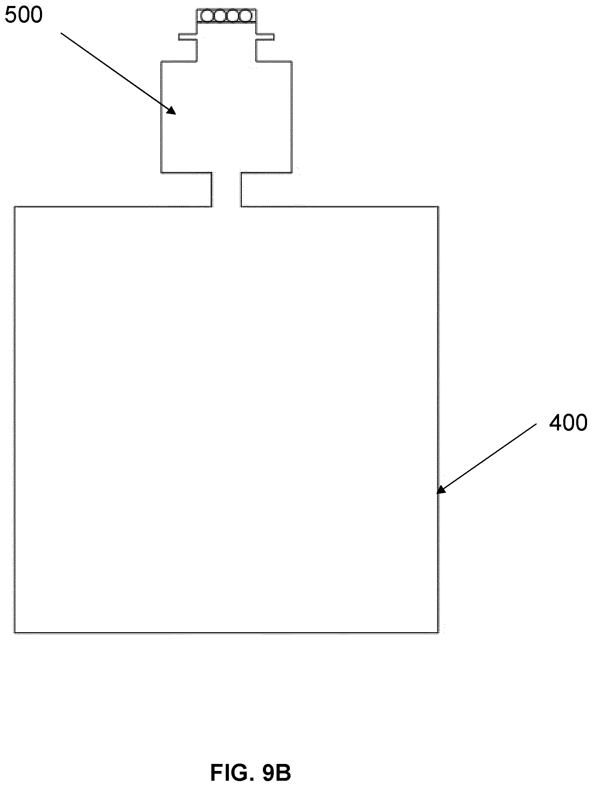

FIG. 9A is a schematic diagram illustrating a cross-section of a crystal growth device according to some embodiments of the present disclosure. FIG. 9B is a schematic diagram of a structure of a crystal growth device shown according to some embodiments of the present disclosure. The crystal growth device is described in detail in the following in conjunction with FIG. 9A and FIG. 9B. As shown in FIG. 9A and FIG. 9B, the crystal growth device also includes a temperature measurement structure 500. In some embodiments, the temperature measuring structure 500 includes a temperature measuring cavity 501 and a temperature measuring window 502.

The temperature measurement structure 500 is configured to measure a temperature inside the crystal growth device, so as to determine whether the crystal growth is in a suitable temperature range, and to ensure an ability of taking timely measures when the measured temperature is not within a threshold range.

In some embodiments, the crystal growth device further includes a furnace cavity 400. The crucible 100 and the insulation device 200 are disposed inside the furnace cavity 400. An opening 401 is disposed at a top of the furnace cavity 400, and the temperature measurement structure 500 is disposed at the opening 401 and interconnected to the opening 401. In some embodiments, the furnace cavity 400 is in a high temperature environment (e.g., 1200 °C-2000 °C, or 800 °C-1600 °C) during operation. The use of conventional contact temperature measurements affects an accuracy of the temperature measurement, so the temperature of a high temperature furnace is measured in a non-contact temperature measurement manner. In some embodiments, temperature detection is realized by an infrared temperature measurement.

The temperature measurement window 502 may serve as a window for temperature detection. For example, the temperature inside the furnace cavity 400 or inside the crucible 100 is collected by an infrared thermometer. The temperature measurement structure 500 is connected to the opening 401, and the infrared thermometer is able to collect the infrared ray emitted from the furnace cavity 400 through the temperature measurement window 502, so as to realize the temperature measurement. In some embodiments, a material of the temperature measurement window 502 includes an infrared temperature measurement glass (e.g., a barium fluoride crystal glass).

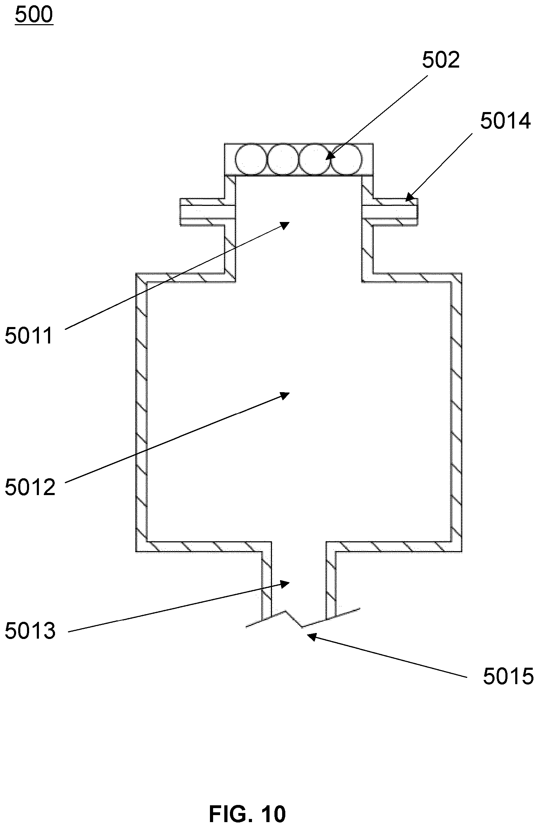

FIG. 10 is a schematic diagram illustrating a structure of a temperature measurement structure according to some embodiments of the disclosure. The temperature measurement structure is described in detail in the following in conjunction with FIG. 10.

In some embodiments, referring to FIG. 10 , the temperature measurement cavity 501 includes a first cavity section 5011, a main body portion 5012, and a second cavity section 5013. The temperature measurement window 502 is disposed in the first cavity section 5011, and the second cavity section 5013 is connected to the furnace cavity 400 to realize a temperature monitoring in the furnace cavity 400. In some embodiments, the growth cavity 101 is in vapor communication with the furnace cavity 400 through a seam near the cover body 301 of the crucible 100, which in turn is in vapor communication with the second cavity section 5013. In some embodiments, the second cavity section 5013 is directly connected to the growth cavity 101 through a temperature measurement hole disposed in the cover body 301, thereby enabling temperature monitoring within the growth cavity.

The first cavity section 5011 refers to a top-end portion of the temperature measurement cavity 501. In some embodiments, the temperature measurement window 502 is disposed in the first cavity section 5011. In some embodiments, the temperature measurement window 502 is disposed at an upper-end surface of the first cavity section 5011.

In some embodiments, the temperature measurement window 502 is parallel or substantially parallel to the upper-end surface of the first cavity section 5011. In some embodiments, the "substantially parallel" refers to that an angle between the temperature measurement window 502 and the upper-end surface of the first cavity section 5011 is within a first preset range.

In some embodiments, the first preset range is -10°-10°. In some embodiments, the first preset range is -8°-8°. In some embodiments, the first preset range is -6°-6°. In some embodiments, the first preset range is-5°-5°. In some embodiments, the first preset range is -2°-2°. In some embodiments, the first preset range is 0°-1°. In some embodiments, the first preset range is 1°-2°.

In some embodiments, the temperature measurement window 502 is non-parallel to the upper-end surface of the first cavity section 5011, and an angle between the temperature measurement window 502 and the upper-end surface of the first cavity section 5011 is within a second preset range. In some embodiments, the second preset range is 10°-60°. In some embodiments, the second preset range is 15°-55°. In some embodiments, the second preset range is 20°-50°. In some embodiments, the second preset range is 25°-45°. In some embodiments, the second preset range is 30°-40°. In some embodiments, the second preset range is 10°-20°. In some embodiments, the second preset range is 20°-30°. In some embodiments, the second preset range is 50°-60°.

The main body portion 5012 refers to a portion between the first cavity section 5011 and the second cavity section 5013. The second cavity section 5013 refers to a bottom portion of the temperature measurement cavity 501. In some embodiments, the second cavity section 5013 is connected to the furnace cavity 400.

In some embodiments, the main body portion 5012 is a rotary-type cavity structure. A diameter of the main body portion 5012 is less than a diameter of the furnace cavity 400.

In some embodiments, the diameter of the main body portion 5012 is much less than the diameter of the furnace cavity 400. In some embodiments, a ratio of the diameter of the main body portion 5012 to the diameter of the furnace cavity 400 is within a second preset ratio range. In some embodiments, the second preset ratio range is 1:5-1:25. In some embodiments, the second preset ratio range is 1:8-1:22. In some embodiments, the second preset ratio range is 1:11-1:19. In some embodiments, the second preset ratio range is 1:14-1:16. In some embodiments, the second preset ratio range is 1:5-1:20. In some embodiments, the second preset ratio range is 1:10-1:25. In some embodiments, the second preset ratio range is 1:5-1:15. In some embodiments, the second preset ratio range is 1:15-1:25.

By disposing the diameter of the main body portion 5012 to be smaller than the diameter of the furnace cavity 400, a size of the temperature measurement cavity 501 is generally smaller than a size of the furnace cavity 400, and an effect of the temperature measurement cavity 501 on a crystal growth environment inside the furnace cavity 400 is reduced.

In some embodiments, the main body portion 5012 is a gradient section, i.e., the diameter of the main body portion 5012 decreases from an end connected to the first cavity section 5011 to an end connected to the second cavity section 5013. That is, the shape of the entire temperature measurement cavity 501 is similar to a shape that gradually decreases from an upper end to a lower end.

In some embodiments, a diameter of the first cavity section 5011 and a diameter of the second cavity section 5013 are both less than the diameter of the main body portion 5012. That is, the entire temperature measurement cavity 501 is similarly shaped to be small at both ends and great in a middle portion.

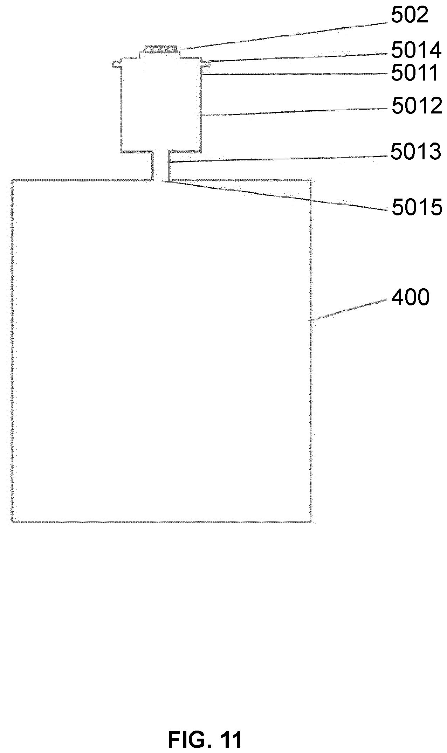

In some embodiments, referring to FIG. 11 , the diameter of the second cavity section 5013 is less than the diameter of the body portion 5012, and the diameter of the first cavity section 5011 is greater than or equal to the diameter of the body portion 5012. That is, the shape of the entire temperature measurement cavity 501 is similar to a shape with a large upper end and a small lower end.

By disposing the temperature measurement cavity 501 into a shape with two small ends and a large middle portion, or a large end and a small end, or a gradually decreasing shape from the upper end to the lower end, a gas concentration in the temperature measurement cavity 501 is greater than a gas concentration in the furnace cavity 400, where a gas pressure in the temperature measurement cavity 501 is greater than a gas pressure of the gas in the furnace cavity 400. Such gas pressure difference makes it difficult for dust generated in the furnace cavity 400 to enter the temperature measurement cavity 501 and reach the temperature measurement window 502, thereby ensuring a cleanliness of the temperature measurement window 502, which is conducive to improving a stability and an accuracy of the temperature measurement.

As shown in FIG. 10, in some embodiments, the temperature measurement structure also includes an air inlet 5014 and an air outlet 5015.

The air inlet 5014 is configured to access gas into the temperature measurement cavity 501. In some embodiments, the air inlet 5014 is disposed in the first cavity section 5011. In some embodiments, the air inlet 5014 is disposed in a sidewall of the first cavity section 5011. In some embodiments, the air inlet 5014 is disposed on the furnace cavity 400 independent from the temperature measurement cavity 501. In some embodiments, taking a crystal growth as an example, the gas enters the temperature measurement cavity 501 through the air inlet 5014 is the gas required for the crystal growth, e.g., oxygen or an inert gas. The inert gas includes nitrogen, helium, neon, xenon, radon, etc., or any combination thereof.

In some embodiments, the air inlet 5014 is disposed near the temperature measurement window 502. In some embodiments, the "near" refers to that a distance between the air inlet 5014 and the temperature measurement window 502 is within a preset distance range.

In some embodiments, the preset distance range is 1 cm-10 cm. In some embodiments, the preset distance range is 3 cm-8 cm. In some embodiments, the preset distance range is 5 cm-6 cm. In some embodiments, the preset distance range is 1 cm-3 cm. In some embodiments, the preset distance range is 3 cm-5 cm. In some embodiments, the preset distance range is 5 cm-8 cm. In some embodiments, the preset distance range is 8 cm-10 cm.

In some embodiments, the distance between the air inlet 5014 and the temperature measurement window 502 is determined based on an inlet airflow of the air inlet 5014 or an inlet direction of the air inlet 5014. For example, the greater the inlet airflow of the air inlet 5014, the greater the distance between the air inlet 5014 and the temperature measurement window 502; and the less the inlet airflow, the less the distance between the air inlet 5014 and the temperature measurement window 502. As another example, the smaller an angle between the inlet direction of the air inlet 5014 and a normal of an inner side surface of the temperature measurement window 502, the greater the distance between the air inlet 5014 and the temperature measurement window 502; and the greater the angle between the inlet direction of the air inlet 5014 and the normal of the inner side surface of the temperature measurement window 502, the less the distance between the air inlet 5014 and the temperature measurement window 502. In some embodiments, the inlet airflow of the air inlet 5014 is set according to an actual demand under a premise that a crystal growth demand is satisfied, and the gas is able to blow the inner side of the temperature measurement window 502.

In some embodiments, the inlet direction of the air inlet 5014 is set toward (e.g., with an angle) the temperature measurement window 502. In some embodiments, the angle between the inlet direction of the air inlet 5014 and a plane of the temperature measurement window 502 is within a preset angle range.

In some embodiments, the preset angle range is 5°-60°. In some embodiments, the preset angle range is 10°-55°. In some embodiments, the preset angle range is 15°-50°. In some embodiments, the preset angle range is 20°-45°. In some embodiments, the preset angle range is 25°-40°. In some embodiments, the preset angle range is 30°-35°. In some embodiments, the preset angle range is 5°-20°. In some embodiments, the preset angle range is 5°-40°. In some embodiments, the preset angle range is 25°-60°.

In some embodiments, the angle between the inlet direction of the air inlet 5014 and the plane of the temperature measurement window 502 is determined based on a size of the temperature measurement window 502 or the distance between the air inlet 5014 and the temperature measurement window 502. For example, the greater the size of the temperature measurement window 502, the greater the angle between the inlet direction of the air inlet 5014 and the plane of the temperature measurement window 502; and the smaller the size of the temperature measurement window 502, the smaller the angle between the inlet direction of the air inlet 5014 and the plane of the temperature measurement window 502. As another example, the less the distance between the air inlet 5014 and the temperature measurement window 502, the greater the angle between the inlet direction of the air inlet 5014 and the plane of the temperature measurement window 502; and the greater the distance between the air inlet 5014 and the temperature measurement window 502, the smaller the angle between the inlet direction of the air inlet 5014 and the plane of the temperature measurement window 502.

By disposing the air inlet 5014 near the temperature measurement window 502 and disposing the inlet direction facing the temperature measurement window 502, the gas entering the temperature measurement cavity 501 from the air inlet 5014 blows at least a portion of the dust on the inner surface of the temperature measurement window 502, so as to sweep and clean the temperature measurement window 502, thus improving the stability and the accuracy of a temperature measurement result.

In some embodiments, the air outlet 5015 is configured to access gas into the furnace cavity 400. In some embodiments, the air outlet 5015 is disposed in the second cavity section 5013. In some embodiments, the air outlet 5015 is disposed at a bottom end surface of the second cavity section 5013. In some embodiments, the air outlet 5015 is connected to the air inlet 5014 of the furnace cavity 400. In some embodiments, the air outlet 5015 is disposed directly on the furnace cavity 400 and is interconnected with the second cavity section 5013.

By disposing the air inlet 5014 in the first cavity section 5011 and the air outlet 5015 in the second cavity section 5012, and by connecting two ends of the less-diameter second cavity section 5013 to the greater-diameter main body portion 5012 and the furnace cavity 400, a Venturi tube structure is formed. As a direction of the air flow is from the first cavity section 5011 to the main body portion 5012, a pressure at an end of the second cavity section 5013 near the main body portion 5012 is greater than a pressure at an end of the second cavity section 5013 near the furnace cavity 400. Such a pressure difference makes it difficult for the dust generated in the furnace cavity 400 to enter the temperature measurement cavity 501 and then reach the temperature measurement window 502, thereby ensuring a cleanliness of the temperature measurement window 502, and thereby contributing to the improvement of the stability and the accuracy of the temperature measurement.

In some embodiments, the pressure difference between the main body portion 5012 and the furnace cavity 400 is adjusted by disposing a proportional relationship between the diameter of the second cavity section 5012 or the diameter of the air outlet 5015 and the diameters of the other portions of the temperature measurement structure (e.g., the air inlet 5014, the main body portion 5012, the furnace cavity 400, etc.), so as to achieve the effect of a better assurance of the cleanliness of the temperature-measuring window 502.

In some embodiments, the diameter of the air outlet 5015 is less than the diameter of the main body portion 5012. In some embodiments, the diameter of the air outlet 5015 is much less than the diameter of the main body portion 5012. In some embodiments, a ratio of the diameter of the air outlet 5015 to the diameter of the main body portion 5012 is within a first preset ratio range.

In some embodiments, the first preset ratio range is 1:5-1:20. In some embodiments, the first preset ratio range is 1:8-1:17. In some embodiments, the first preset ratio range is 1:11-1:14. In some embodiments, the first preset ratio range is 1:5-1:15. In some embodiments, the first preset ratio range is 1:10-1:20.

By disposing the diameter of the air outlet 5015 to be less than the diameter of the main body portion 5012 (or the ratio of the diameters of the two is within a preset range), it is possible to make the gas pressure within the temperature measurement cavity 501 greater than the gas pressure within the furnace cavity 400, and such a pressure difference makes it not easy for the dust generated within the furnace cavity 400 to enter the temperature measurement cavity 501 and then reach the temperature measurement window 502, so as to ensure the cleanliness of the temperature measurement window 502, thereby improving the stability and the accuracy of the temperature measurement.

In some embodiments, the diameter of the body portion 5012 is less than the diameter of the furnace cavity 400. In some embodiments, the diameter of the main body portion 5012 is much less than the diameter of the furnace cavity 400. In some embodiments, a ratio of the diameter of the main body portion 5012 to the diameter of the furnace cavity 400 is within a second preset ratio range. In some embodiments, the second preset ratio range is 1:5-1:25. In some embodiments, the second preset ratio range is 1:8-1:22. In some embodiments, the second preset ratio range is 1:11-1:19. In some embodiments, the second preset ratio range is 1:14-1:16. In some embodiments, the second preset ratio range is 1:5-1:20. In some embodiments, the second preset ratio range is 1:10-1:25. In some embodiments, the second preset ratio range is 1:5-1:15. In some embodiments, the second preset ratio range is 1:15-1:25.

In some embodiments, the diameter of the air outlet 5015 is less than the diameter of the air inlet 5014.

In some embodiments, the ratio of the diameter of the air outlet 5015 to the diameter of the air inlet 5014 is within a third preset ratio range. In some embodiments, the third preset ratio range is 1:1.5-1:5. In some embodiments, the third preset ratio range is 1:2-1:4.5. In some embodiments, the third preset ratio range is 1:2.5-1:4. In some embodiments, the third preset ratio range is 1:3-1:3.5. In some embodiments, the third preset ratio range is 1:1.5-1:3.5. In some embodiments , the third preset ratio range is 1:3-1:5.

By setting the diameter of the air outlet 5015 to be less than the diameter of the air inlet 5014, it is possible to make the gas concentration in the temperature measurement cavity 501 greater than the gas concentration in the furnace cavity 400 (the gas pressure in the temperature measurement cavity 501 is greater than the gas pressure in the furnace cavity 400). Such pressure difference makes it difficult for the dust generated in the furnace cavity 400 to enter the temperature measurement cavity 501 and reach the temperature measurement window 502, thereby ensuring the cleanliness of the temperature measurement window 502, which is conducive to improving the stability and the accuracy of the temperature measurement.

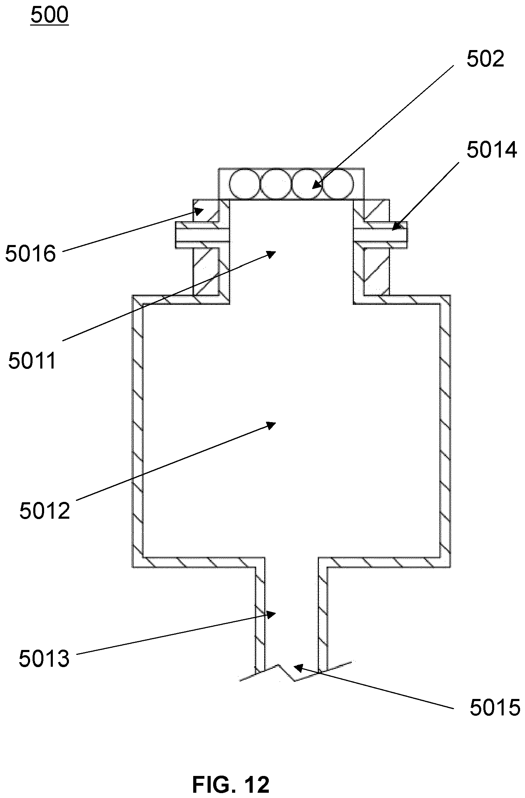

FIG. 12 is a schematic diagram illustrating a structure of a temperature measurement structure according to some embodiments of the present disclosure. The temperature measurement structure is described in detail in the following in connection with FIG. 9. As shown in FIG. 12, in some embodiments, the temperature measurement structure also includes a heater 5016.

The heater 5016 is configured to heat the main body portion 5012. In some embodiments, the heater 5016 wraps around or surrounds an outer surface of the main body portion 5012 or in a peripheral space of the outer surface of the main body portion 5012 to evenly heat the main body portion 5012.

In some embodiments, the heater 5016 includes a resistance heating assembly, an induction heating assembly, etc.

By heating the main body portion 5012, it is possible to make a temperature of gas in the temperature measurement cavity 501 higher than a temperature of gas in the furnace cavity 400, which makes a gas pressure in the temperature measurement cavity 501 higher than the gas pressure in the furnace cavity 400. Such a pressure difference makes it not easy for dust generated in the furnace cavity 400 to enter the temperature measurement window 502 and reach the temperature measurement window 502, thus ensuring a cleanliness of the temperature measurement window 502, thereby contributing to an improvement of a stability and an accuracy of temperature measurement.

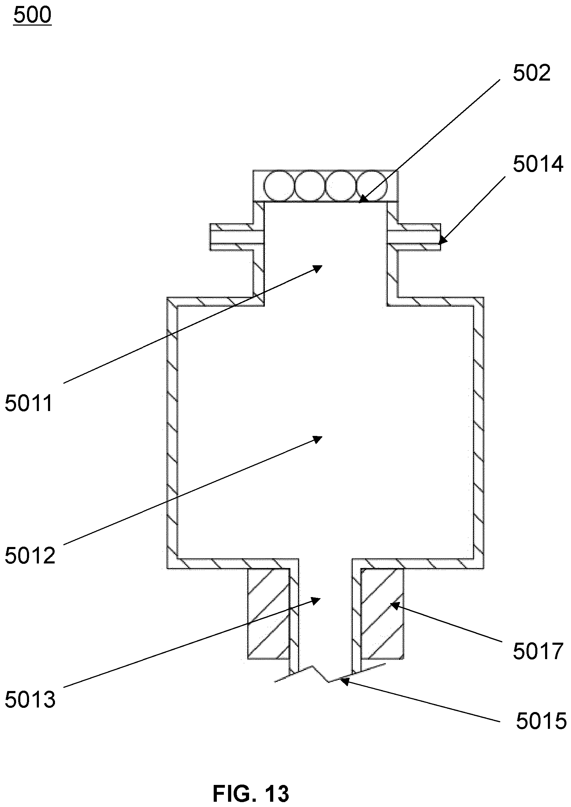

FIG. 13 is a schematic diagram illustrating a structure of a temperature measurement structure according to some embodiments of the present disclosure. The temperature measurement structure is described in detail in the following in conjunction with FIG. 10. As shown in FIG. 13, in some embodiments, the temperature measurement structure also includes a cooler 5017. The cooler 5017 is configured to cool the second cavity section 5013.

In some embodiments, a cooling manner of the cooler 5017 includes water cooling, air cooling, etc. In some embodiments, the cooler 5017 is disposed (e.g., wrapped) in an outer surface of the second cavity section 5013 or in a peripheral space of the outer surface to evenly cool the second cavity section 5013.

By disposing the cooler 5017 on the outer surface of the second cavity section 5013, a temperature of the second cavity section 5013 is made lower than the temperature of the main body portion 5012 so as to further increase a pressure difference between the main body portion 5012 and the second cavity section 5013, and dust generated in the furnace cavity 400 is cold, which condenses when arriving near the second cavity section 5013, thereby effectively preventing the dust from easily entering the temperature measurement cavity 501 and reaching the temperature measurement window 502. As a result, a deposition of the dust on an inside of the temperature measurement window 502 is effectively prevented.

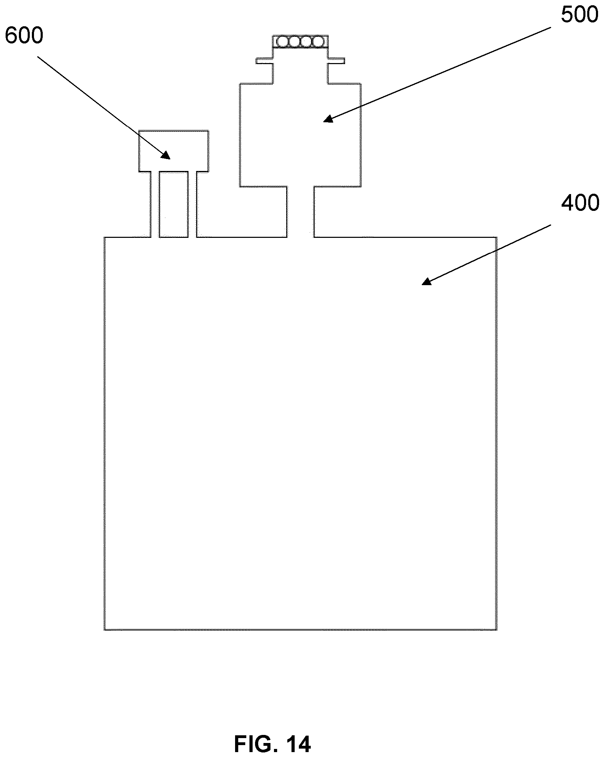

FIG. 14 is a schematic diagram illustrating a structure of a temperature measurement structure according to some embodiments of the present disclosure. The temperature measurement structure is described in detail in the following in conjunction with FIG. 11. As shown in FIG. 14, in some embodiments, the temperature measurement structure also includes a deposition cavity 600. The deposition cavity 600 is connected to the furnace cavity 400 for depositing dust generated within the furnace cavity 400.

In some embodiments, the deposition cavity 600 is closed at one end and connected to the furnace cavity 400 at the other end. In some embodiments, two or more connecting holes are opened in the deposition cavity 600. Each of the two connecting holes is respectively connected to the furnace cavity 400 through separate channels, and the gas within the furnace cavity 400 passes through the channels into the deposition cavity 600.

In some embodiments, there are two deposition cavities 600 symmetrically disposed on either side of the furnace cavity 400, so as to balance an impact on the environment within the furnace cavity 400 as much as possible. In some embodiments, there are one, three, or more deposition cavities 600, and the present disclosure does not limit this.

As a liquidity of the gas in the deposition cavity 600 is poorer relative to the liquidity of the gas in the furnace cavity 400, the dust generated in the furnace cavity 400 is made to be deposited in the deposition cavity by disposing the deposition cavity 600, thereby reducing the dust entering the temperature measurement cavity, and effectively preventing the deposition of dust on the inside of the temperature measurement window 502.

In some embodiments, a temperature within the deposition cavity 600 is lower than the temperature within the furnace cavity 400. In some embodiments, the temperature within the deposition cavity 600 is controlled by cooling the deposition cavity 600 with a cooler. The cooler is disposed in a manner similar to that of the foregoing cooler 5017, which is not described herein.

By controlling the temperature within the deposition cavity 600 to be lower than the temperature within the furnace cavity 400, it is possible to make it easier for the dust within the furnace cavity 400 to be cooled and deposited within the deposition cavity 600, thereby reducing the deposition of the dust on the inner side of the temperature measurement window 502.

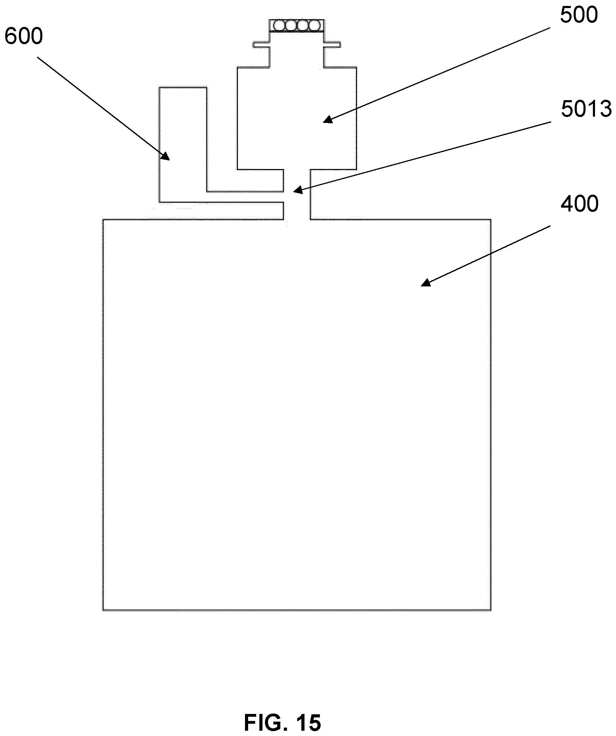

FIG. 15 is a schematic diagram illustrating a structure of a temperature measurement structure according to some embodiments of the present disclosure. The temperature measurement structure is described in detail in the following in connection with FIG. 12. As shown in FIG. 15, in some embodiments, the temperature measurement structure also includes the deposition cavity 600. The deposition cavity 600 contacts the second cavity section 5013 for depositing dust generated within the furnace cavity 400 and moved to a position near the second cavity section 5013.

In some embodiments, the deposition cavity 600 is closed at one end and connected to the second cavity section 5013 at the other end. In some embodiments, the deposition cavity 600 is disposed with two or more connecting holes, with each connecting hole connected to the second cavity section 5013 through a separate channel.

In some embodiments, there are two deposition cavities 600, which are symmetrically disposed on either side of the second cavity section 5013, so that an impact on the environment within the furnace cavity 400 is as balanced as possible. In some embodiments, there are one, three, or more deposition cavities 600, and the present disclosure is not limited thereto.

As a liquidity of gas inside the deposition cavity 600 is poorer relative to the liquidity of the gas inside the temperature measurement cavity 501 and the furnace cavity 400, by disposing the deposition cavity 600, when the dust generated inside the furnace cavity 400 moves to a position near the second cavity section 5013, the dust is easily deposited in the deposition cavity, thereby reducing the dust entering the temperature measurement cavity 501 and effectively preventing the deposition of the dust on an inside of the temperature measurement window 502.

In some embodiments, a temperature within the deposition cavity 600 is lower than a temperature within the furnace cavity 400 and a temperature within the temperature measurement cavity 501, and a pressure within the deposition cavity 600 is lower than a pressure within the temperature measurement cavity 501.

In some embodiments, the temperature within the deposition cavity 600 is controlled by cooling the deposition cavity 600 with a cooler. The cooler is disposed in a manner similar to the manner of the aforementioned cooler 5017, which is not described herein.

By controlling the temperature within the deposition cavity 600 to be lower than the temperature within the furnace cavity 400 and the temperature within the temperature measurement cavity 501, and controlling the pressure within the deposition cavity 600 to be lower than the pressure within the temperature measurement cavity 501, the dust within the furnace cavity 400 is made to be more easily cooled and deposited into the deposition cavity 600, thereby reducing the deposition of dust on the inside of the temperature measurement window 502.

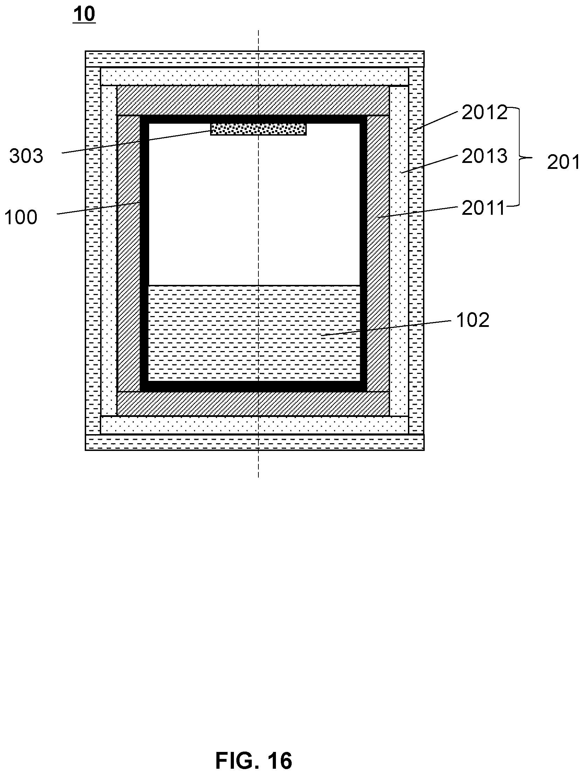

FIG. 16 is a schematic diagram illustrating a structure of a crystal growth device according to some embodiments of the present disclosure.

In some embodiments, the insulation device 200 includes a first insulation assembly 201. In some embodiments, the first insulation assembly 201 is at least disposed on a circumferential side of the crucible 100. In some embodiments, the first insulation assembly 201 is disposed merely on the circumferential side of the crucible 100. In some embodiments, the first insulation assembly 201 is disposed on both the circumferential side and a bottom side of the crucible 100. In some embodiments, the first insulation assembly 201 is also disposed on both the circumferential side and a top side of the crucible 100. In some embodiments, the first insulation assembly 201 is also disposed on both the circumferential side, the top side, and the bottom side of the crucible 100. In some embodiments, the first insulation assembly 201 includes an inner layer 2011, an outer layer 2012, and a middle layer 2013. The middle layer 2013 is disposed between the inner layer 2011 and the outer layer 2012. By disposing a multi-layer insulation structure combining the inner layer, the outer layer, and the middle layer, the middle layer maintains a good insulation effect when the inner layer volatilizes due to heat and becomes thinner and when the outer layer deteriorates in its insulation performance due to a deposition of impurities. Meanwhile, an independent structure facilitates replacing the inner layer or the outer layer, so as to reduce a cost of maintenance of the insulation device and improve an efficiency of maintenance of the insulation device.

In some embodiments, the thickness of the inner layer 2011 needs to satisfy a preset condition to avoid too high a replacement frequency due to a too small thickness and too high a cost due to a too great thickness. In addition, the inner layer 2011 is disposed as an independent structure along an axial direction to maintain a good insulation effect at different positions in the axial direction, and at the same time, to facilitate targeted maintenances and replacements in response to wear and tear at different positions. Described regarding the inner layer 2011 is in detail below.

In some embodiments, considering the cost of the inner layer 2011 and the replacement frequency, the thickness of the inner layer 2011 is set within a certain thickness range. In some embodiments, the thickness of the inner layer 2011 is in a range of 4 mm-57 mm. In some embodiments, the thickness of the inner layer 2011 is in a range of 5 mm-55 mm. In some embodiments, the thickness of the inner layer 2011 is in a range of 7 mm-52 mm. In some embodiments, the thickness of the inner layer 2011 is in a range of 10 mm-50 mm. In some embodiments, the thickness of the inner layer 2011 is in a range of 13 mm-47 mm. In some embodiments, the thickness of the inner layer 2011 is in a range of 15 mm-45 mm. In some embodiments, the thickness of the inner layer 2011 is in a range of 17 mm-43 mm. In some embodiments, the thickness of the inner layer 2011 is in a range of 20 mm-40 mm. In some embodiments, the thickness of the inner layer 2011 is in a range of 22 mm-37 mm. In some embodiments, the thickness of the inner layer 2011 is in a range of 25 mm-35 mm. In some embodiments, the thickness of the inner layer 2011 is in a range of 27 mm-32 mm. In some embodiments, the thickness of the inner layer 2011 is in a range of 28 mm-30 mm.

By disposing the thickness of the inner layer within a certain thickness range, an initial cost of the inner layer is reduced, and the replacement frequency of the inner layer and the cost of the replacement are reduced, so as to improve a service life of the inner layer, and to maintain a process stability of a crystal growth process.

In some embodiments, to ensure that the middle layer 2013 maintains a good and stable insulation effect when the inner layer 2011 and the outer layer 2012 are depleted, and considering the cost at the same time, the thickness of the middle layer 2013 needs to be set within a certain range. In some embodiments, the thickness of the middle layer 2013 is in a range of 28 mm-143 mm. In some embodiments, the thickness of the middle layer 2013 is in a range of 30 mm-140 mm. In some embodiments, the thickness of the middle layer 2013 is in a range of 35 mm-135 mm. In some embodiments, the thickness of the middle layer 2013 is in a range of 40 mm-130 mm. In some embodiments, the thickness of the middle layer 2013 is in a range of 45 mm-135 mm. In some embodiments, the thickness of the middle layer 2013 is in a range of 50 mm-130 mm. In some embodiments, the thickness of the middle layer 2013 is in a range of 55 mm-125 mm. In some embodiments, the thickness of the middle layer 2013 is in a range of 60 mm-120 mm. In some embodiments, the thickness of the middle layer 2013 is in a range of 65 mm-115 mm. In some embodiments, the thickness of the middle layer 2013 is in a range of 70 mm-110 mm. In some embodiments, the thickness of the middle layer 2013 is in a range of 75 mm-105 mm. In some embodiments, the thickness of the middle layer 2013 is in a range of 80 mm-100 mm. In some embodiments, the thickness of the middle layer 2013 is in a range of 85 mm-95 mm. In some embodiments, the thickness of the middle layer 2013 is in a range of 88 mm-90 mm.

By disposing the thickness of the middle layer in a certain range, the crucible and the impurities generated by the volatilization of the inner layer of the crucible due to heat is volatilized to the outer layer instead of staying in the middle layer, and the insulation effect of the middle layer is not affected. Accordingly, the middle layer maintains a good and stable insulation effect when the inner layer thins out due to a loss, and when the outer layer has impurity deposition, the middle layer still maintains a good and stable insulation effect. Then there is no need to replace the middle layer in the production process, which saves the production cost.

In some embodiments, to maximize the deposition of volatiles in the outer layer rather than in the middle layer, a total thickness of the middle layer 2013 and the inner layer 2011 needs to satisfy a certain condition. In some embodiments, the total thickness of the middle layer 2013 and the inner layer 2011 is greater than 50 mm. In some embodiments, the total thickness of the middle layer 2013 and the inner layer 2011 is greater than 55 mm. In some embodiments, the total thickness of the middle layer 2013 and the inner layer 2011 is greater than 60 mm. In some embodiments, the total thickness of the middle layer 2013 and the inner layer 2011 is greater than 65 mm. In some embodiments, the total thickness of the middle layer 2013 and the inner layer 2011 is greater than 70 mm. In some embodiments, the total thickness of the middle layer 2013 and the inner layer 2011 is greater than 75 mm. In some embodiments, the total thickness of the middle layer 2013 and the inner layer 2011 is greater than 80 mm.

By disposing the total thickness of the middle layer and the inner layer to be greater than a certain value, the temperature of an outer side of the middle layer is made as high as possible above the temperature at which the volatiles are deposited or crystallized, so as to make the volatiles deposited in the outer layer instead of in the middle layer, and thus to maintain a good thermal insulation effect of the middle layer.

In some embodiments, the thickness of the middle layer 2013 is greater than both the thickness of the inner layer 2011 and the thickness of the outer layer 2012. By disposing the thickness of the middle layer to be greater than the thickness of the inner layer and the thickness of the outer layer, it is ensured that the middle layer maintains a good and stable insulation effect when the insulation effect varies due to the loss of the inner layer and the deposition of impurities on the outer layer, so as to reduce the effect of the loss of the inner layer and the impurity deposition of the outer layer on the insulation performance of the whole insulation device, improve the stability of the insulation performance, and when the inner layer needs to be replaced due to the loss and thinning, the middle layer plays a supporting role, and improve a structural stability of the insulation device.

In some embodiments, considering the cost of replacement in the actual production process and the actual insulation effect, the thickness of the outer layer 2012 needs to be set within a certain thickness range. In some embodiments, the thickness of the outer layer 2012 is in a range of 7 mm-42 mm. In some embodiments, the thickness of the outer layer 2012 is in a range of 10 mm-40 mm. In some embodiments, the thickness of the outer layer 2012 is in a range of 12 mm-38 mm. In some embodiments, the thickness of the outer layer 2012 is in a range of 15 mm-35 mm. In some embodiments, the thickness of the outer layer 2012 is in a range of 17 mm-33 mm. In some embodiments, the thickness of the outer layer 2012 is in a range of 20 mm-30 mm. In some embodiments, the thickness of the outer layer 2012 is in a range of 22 mm-28 mm. In some embodiments, the thickness of the outer layer 2012 is in a range of 25 mm-27 mm.

In some embodiments, combining the above, considering an overall maintenance cost of the insulation device and the insulation effect, a total thickness of the inner layer 2011, the middle layer 2013, and the outer layer 2012 needs to be set within a certain range. In some embodiments, the total thickness of the inner layer 2011, the middle layer 2013, and the outer layer 2012 is in a range of 50 mm-200 mm. In some embodiments, the total thickness of the inner layer 2011, the middle layer 2013, and the outer layer 2012 is in a range of 60 mm-190 mm. In some embodiments, the total thickness of the inner layer 2011, the middle layer 2013, and the outer layer 2012 is in a range of 70 mm-180 mm. In some embodiments, the total thickness of the inner layer 2011, the middle layer 2013, and the outer layer 2012 is in a range of 80 mm-170 mm. In some embodiments, the total thickness of the inner layer 2011, the middle layer 2013, and the outer layer 2012 is in a range of 90 mm-160 mm. In some embodiments, the total thickness of the inner layer 2011, the middle layer 2013, and the outer layer 2012 is in a range of 100 mm-150 mm. In some embodiments, the total thickness of the inner layer 2011, the middle layer 2013, and the outer layer 2012 is in a range of 110 mm-140 mm. In some embodiments, the total thickness of the inner layer 2011, the middle layer 2013, and the outer layer 2012 is in a range of 120 mm-130 mm.

In some embodiments, in conjunction with the above, considering the overall maintenance cost of the insulation device and the insulation effect, a thickness ratio of the inner layer 2011 to the middle layer 2013 needs to be set within a certain range. In some embodiments, the thickness ratio of the inner layer 2011 to the middle layer 2013 is in a range of 1:2-1:10. In some embodiments, the thickness ratio of the inner layer 2011 to the middle layer 2013 is in a range of 1:3-1:9. In some embodiments, the thickness ratio of the inner layer 2011 to the middle layer 2013 is in a range of 1:4-1:8. In some embodiments, the thickness ratio of the inner layer 2011 to the middle layer 2013 is in a range of 1:5-1:7. In some embodiments, the thickness ratio of the inner layer 2011 to the middle layer 2013 is 1:6.

In some embodiments, in conjunction with the above, considering the overall maintenance cost of the insulation device and the insulation effect, the thickness ratio of the middle layer 2013 to the outer layer 2012 needs to be set within a certain range. In some embodiments, the thickness ratio of the middle layer 2013 to the outer layer 2012 is in a range of 2:0.5-10:3. In some embodiments, the thickness ratio of the middle layer 2013 to the outer layer 2012 is in a range of 3:0.5-9:3. In some embodiments, the thickness ratio of the middle layer 2013 to the outer layer 2012 is in a range of 4:0.5-8:3. In some embodiments, the thickness ratio of the middle layer 2013 to the outer layer 2012 is in a range of 5:0.5-7:3. In some embodiments, the thickness ratio of the middle layer 2013 to the outer layer 2012 is in a range of 6:0.5-6:3. In some embodiments, the thickness ratio of the middle layer 2013 to the outer layer 2012 is in a range of 2:1-10:2.5. In some embodiments, the thickness ratio of the middle layer 2013 to the outer layer 2012 is in a range of 2:1.5-10:2. In some embodiments, the thickness ratio of the middle layer 2013 to the outer layer 2012 is in a range of 2:2-10:1.5. In some embodiments, the thickness ratio of the middle layer 2013 to the outer layer 2012 is in a range of 2:3-10:1.

In some embodiments, in conjunction with the above, considering the overall maintenance cost of the insulation device and the insulation effect, the thickness ratio of the inner layer 2011 to the outer layer 2012 needs to be set within a certain range. In some embodiments, the thickness ratio of the inner layer 2011 to the outer layer 2012 is in a range of 1:0.5-1:3. In some embodiments, the thickness ratio of the inner layer 2011 to the outer layer 2012 is in a range of 1:1-1:2.5. In some embodiments, the thickness ratio of the inner layer 2011 to the outer layer 2012 is in a range of 1:1.5-1:2. In some embodiments, the thickness ratio of the inner layer 2011 to the outer layer 2012 is in a range of 1:2-1:1.5. In some embodiments, the thickness ratio of the inner layer 2011 to the outer layer 2012 is in a range of 1:3-1:1.

In some embodiments, in conjunction with the above, considering the overall maintenance cost of the insulation device and the insulation effect, the thickness ratio of the inner layer 2011, the middle layer 2013, and the outer layer 2012 needs to be set within a certain range. In some embodiments, the thickness ratio of the inner layer 2011, the middle layer 2013, and the outer layer 2012 is in a range of 1:2:0.5-1:10:3. In some embodiments, the thickness ratio of the inner layer 2011, the middle layer 2013, and the outer layer 2012 is in a range of 1:2:1-1:10:2.5. In some embodiments, the thickness ratio of the inner layer 2011, the middle layer 2013, and the outer layer 2012 is in a range of 1:2:1.5-1:10:2. In some embodiments, the thickness ratio of the inner layer 2011, the middle layer 2013, and the outer layer 2012 is in a range of 1:2:2-1:10:1.5. In some embodiments, the thickness ratio of the inner layer 2011, the middle layer 2013, and the outer layer 2012 is in a range of 1:2:3-1:10:1. In some embodiments, the thickness ratio of the inner layer 2011, the middle layer 2013, and the outer layer 2012 is in a range of 1:3:0.5-1:9:3. In some embodiments, the thickness ratio of the inner layer 2011, the middle layer 2013, and the outer layer 2012 is in a range of 1:4:0.5-1:8:3. In some embodiments, the thickness ratio of the inner layer 2011, the middle layer 2013, and the outer layer 2012 is in a range of 1:5:0.5-1:7:3. In some embodiments, the thickness ratio of the inner layer 2011, the middle layer 2013, and the outer layer 2012 is in a range of 1:6:0.5-1:6:3.

In some embodiments, a material of the inner layer 2011 includes a graphite felt. By disposing the inner layer to be made of the graphite felt, the insulation performance is ensured to be stable and easy for replacement.

In some embodiments, a material of the outer layer 2012 is different from the material of the inner layer 2011. In some embodiments, the outer layer 2012 is denser than the inner layer 2011. In some embodiments, the material of the outer layer 2012 includes at least one of zirconia, aluminum oxide, a carbon material, or a carbon fiber material.

By disposing an outer layer material that is relatively dense and has a relatively small heat conductivity, the heat volatilized impurities deposited on the outer layer have less effect on the insulation performance of the outer layer, thus making the insulation performance of the thermal insulation device more stable. At the same time, the material of the outer layer has a lower cost than the material of the inner layer, which reduces the overall cost.

In some embodiments, the material of the middle layer 2013 is the same as or different from the material of the inner layer 2011, which is set in conjunction with actual needs or costs. For example, the material of the middle layer 2013 includes the graphite felt, ceramic, etc.

In some embodiments, it is necessary to set an impurity rate in materials of the inner, middle or outer below a certain volume to prevent the impurities in the inner, middle or outer material from entering the crucible during the crystal growth process and causing crystal defects.

In some embodiments, the impurity rate of the material of the inner layer 2011 is less than 100 ppm. In some embodiments, the impurity rate of the material of the inner layer 2011 is less than 90 ppm. In some embodiments, the impurity rate of the material of the inner layer 2011 is less than 80 ppm. In some embodiments, the impurity rate of the material of the inner layer 2011 is less than 70 ppm. In some embodiments, the impurity rate of the material of the inner layer 2011 is less than 60 ppm. In some embodiments, the impurity rate of the inner layer 2011 material is less than 50 ppm.

In some embodiments, the impurity rate of the material of the middle layer 2013 is less than 100 ppm. In some embodiments, the impurity rate of the material of the middle layer 2013 is less than 90 ppm. In some embodiments, the impurity rate of the material of the middle layer 2013 is less than 80 ppm. In some embodiments, the impurity rate of the material of the middle layer 2013 is less than 70 ppm. In some embodiments, the impurity rate of the material of the middle layer 2013 is less than 60 ppm. In some embodiments, the impurity rate of the material of the middle layer 2013 is less than 50 ppm.

In some embodiments, the impurity rate of the material of the outer layer 2012 is less than 100 ppm. In some embodiments, the impurity rate of the material of the outer layer 2012 is less than 90 ppm. In some embodiments, the impurity rate of the material of the outer layer 2012 is less than 80 ppm. In some embodiments, the impurity rate of the material of the outer layer 2012 is less than 70 ppm. In some embodiments, the impurity rate of t the material of the outer layer 2012 is less than 60 ppm. In some embodiments, the impurity rate of the material of the outer layer 2012 is less than 50 ppm.

In some embodiments, impurity transport in the inner, middle or outer layers is affected by two factors, namely, a temperature gradient and a concentration, with a vast majority of the impurity transported outward of the insulation device driven by the temperature gradient. A small amount of the impurities is diffused inward to the crucible driven by the concentration factor. Therefore, to ensure that as few impurities as possible enter the crucible during the crystal growth process and cause crystal defects, the impurity rates of the materials of the inner, middle, and outer layer (especially the inner layer) need to satisfy a certain relationship.

In some embodiments, the inner layer 2011 has a lowest impurity rate. In some embodiments, the impurity rate of the material of the outer layer 2012 is not less than the impurity rate of the material of the middle layer 2013. In some embodiments, the impurity rate of the material of the middle layer 2013 is not less than the impurity rate of the material of the inner layer 2011. In some embodiments, the impurity rate of the material of the outer layer 2012 is not less than the impurity rate of the material of the middle layer 2013 which is not less than the impurity rate of the material of the inner layer 2011.

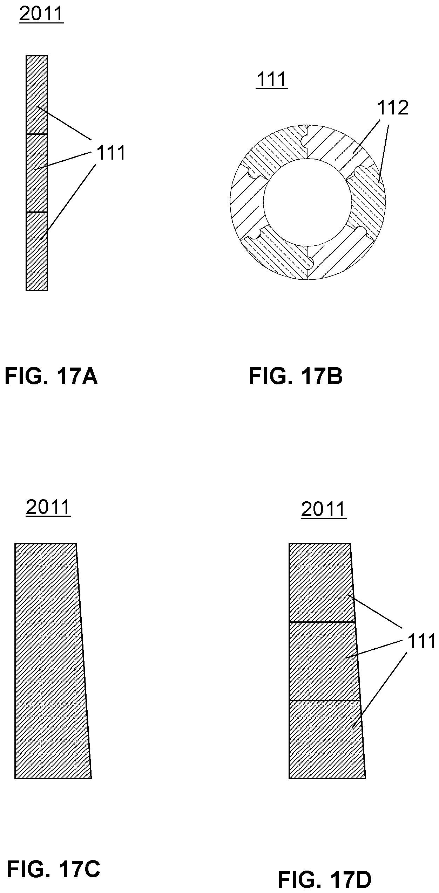

In some embodiments, in the actual crystal growth process, as the inner layer 2011 is set closely outside the crucible and is at a high temperature, the heat volatilization of the impurity in the inner layer 2011 leads to a loss and thinning of the inner layer and a reduction of the insulation performance. Therefore, the inner layer 2011 is designed as an independent replaceable structure, which is convenient for subsequent replacement. In addition, in conjunction with the foregoing, as an axial temperature gradient is required in the crystal growth process, accordingly, temperatures at different positions in an axial direction are different, and the required insulation performances thereof are also different. Therefore, the inner layer 2011 is designed with different thicknesses along the axial direction according to the temperature gradient, and accordingly, a good insulation effect is maintained at the different positions in the axial direction, and at the same time, it facilitates a targeted maintenance or replacement for the wear and tear at different positions. The following is a detailed description of the structure of the inner layer 2011 in conjunction with FIGs. 17A-17D.

In some embodiments, the inner layer 2011 includes at least two insulation sections 111, as shown in FIG. 17A. In some embodiments, the at least two insulation sections 111 are stacked top and down. In some embodiments, the insulation sections 111 are annular insulation sections, and the at least two annular insulation sections are stacked up and down to form a cylindrical structure. In some embodiments, to ensure a stability of the inner layer 2011 formed by the top and down stacking, upper and lower contacting surfaces of the two adjacent insulation sections 111 are made as a nested structure. For example, for the two adjacent insulation sections 111, a convex is disposed on the lower surface of the upper insulation section 111, and a groove corresponding the convex is disposed on the upper surface of the lower insulation section 111, so that the two adjacent insulation sections are more tightly fitted after the top and down stacking.

In some embodiments, each of the insulation sections 111 includes at least two insulation blocks 112, as shown in FIG. 17B. In some embodiments, the at least two insulation blocks 112 are block spliced along a circumference to form the annular structure. In some embodiments, to ensure a stability of the insulation section 111 formed by block splicing along the circumference, two contact surfaces of two adjacent insulation blocks 112 are made as a nested structure. For example, for the two adjacent insulation blocks 112, a contact surface of one insulation block 112 is disposed with the convexes, and the contact surface of the other insulation block 112 contacting thereto is disposed with corresponding grooves, so that the two adjacent insulation blocks, after being block-spliced along the circumference, fit together more closely and securely.

In some embodiments, the inner layer 2011 varies in thickness along the axial direction, as shown in FIG. 17C. In some embodiments, the thickness of the inner layer 2011 along the axial direction is designed based on a temperature field distribution (or the temperature gradient).

By disposing the inner layer varying in thickness along the axial direction (e.g. designing the thickness of the inner layer along the axial direction based on a temperature field distribution), the thickness of the inner layer is adjusted according to an actual temperature field distribution, and a targeted replacement is performed on the wear and tear of the inner layer in different positions of the inner layer (e.g. replacing only one or more insulation sections or blocks at a time), which correspondingly maintains a good insulation effect, and at the same time, the production cost is saved.

In some embodiments, the inner layer 2011 varies in thickness along the axial direction and is disposed as at least two insulation sections 111 stacked up and down, as shown in FIG. 17D.

In some embodiments, as the structure and insulation properties of the middle layer 2013 change less with a service time, the middle layer 2013 is of an integrated structure (e.g., an integrated insulation cartridge), which facilitates mounting of the middle layer and maintains the good insulation effect. The integrated structure is also supportive when replacing the inner layer, so as to improve a structural stability of the insulation device.

In some embodiments, the inner layer 2011 and the middle layer 2013 closely fit with each other. In some embodiments, the middle layer 2013 and the outer layer 2012 closely fit with each other.

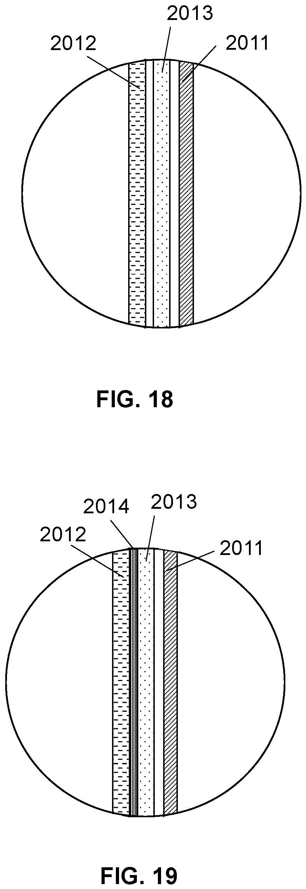

In some embodiments, a gap is disposed between the inner layer 2011 and the middle layer 2013, as shown in FIG. 18. In some embodiments, a gap is deposed between the middle layer 2013 and the outer layer 2012. In some embodiments, a size of the gap between the inner layer 2011 and the middle layer 2013 is the same as or different from a size of the gap between the middle layer 2013 and the outer layer 2012. In some embodiments, the size of the gap between the inner layer 2011 and the middle layer 2013 is a shortest distance between the outer side of the inner layer 2011 and the inner side of the middle layer 2013. In some embodiments, the size of the gap between the middle layer 2013 and the outer layer 2012 is the shortest distance between the outer side of the middle layer 2013 and the inner side of the outer layer 2012.

In some embodiments, the size of the gap is in a range of 0 mm-10 mm. In some embodiments, the size of the gap is in a range of 1 mm-9 mm. In some embodiments, the size of the gap is in a range of 2 mm-8 mm. In some embodiments, the size of the gap is in a range of 3 mm-7 mm. In some embodiments, the size of the gap is in a range of 4 mm-6 mm. In some embodiments, the size of the gap is in a range of 4 mm-5 mm.

In some embodiments, the gap between the inner layer 2011 and the middle layer 2013 is not filled with an insulation material, as shown in FIG. 18. In some embodiments, the gap between the middle layer 2013 and the outer layer 2012 is not filled with the insulation material, as shown in FIG. 18.

As a heat conductivity rate of the air in the gap is lower than the heat conductivity rate of the solid, the air in the gap acts as an insulation layer for insulation. At the same time, gaps between the inner layer, middle layer, and outer layer help to replace the inner layer later.

In some embodiments, the gap between the inner layer 2011 and the middle layer 2013 is filled with an insulation material. In some embodiments, the gap between the middle layer 2013 and the outer layer 2012 is filled with the insulation material. In some embodiments, the insulation material includes one or more of granules, a felt, or a brick. In some embodiments, the insulation material includes one or more of silicon oxide, alumina, zirconia, graphite, carbon fiber, or ceramic. In some embodiments, the gap between the inner layer 2011 and the middle layer 2013 is filled with a graphite soft felt.

In some embodiments, the gap between the inner layer 2011 and the middle layer 2013 is filled with the insulation material, and the gap between the middle layer 2013 and the outer layer 2012 is not filled with the insulation material. In some embodiments, the gap between the inner layer 2011 and the middle layer 2013 is not filled with the insulation material, and the gap between the middle layer 2013 and the outer layer 2012 is filled with the insulation material.

By filling the gap between the inner layer and the middle layer and the gap between the middle layer and the outer layer with the insulation material, the insulation property of the insulation device is improved, which helps to regulate the temperature of the outer layer, so that the temperature of the outer layer reaches a preset temperature (e.g., the temperature set before the crystal growth). In addition, due to the fact that the insulation material (e.g., the graphite soft felt) is easily removed for the replacement of the inner layer, and the insulation material is reloaded into the gap and reused after replacement of the inner layer, the production costs are saved.

In some embodiments, as shown in FIG. 19, graphite paper 2014 is filled between the middle layer 2013 and the outer layer 2012. Because of a low porosity of the graphite paper, it is difficult for the volatiles to pass through and deposit on the surface thereof, so the graphite paper is used as a pre-deposited layer of volatiles, and accordingly, the volatiles deposited on the outer layer is reduced, and the loss of the outer layer is reduced. At the same time, the graphite paper is easy to replace and low-cost, which improves the stability of insulation performance and reduces the production costs.

In some embodiments, other less porous materials are filled between the middle layer 2013 and the outer layer 2012, and the present disclosure does not limit this.

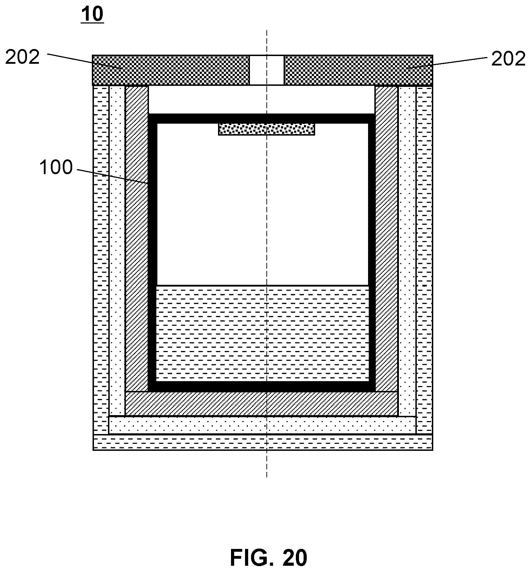

In some embodiments, the insulation device 200 further includes a second insulation assembly 202. The second insulating assembly 202 is disposed at a top of the crystal growth device 10. For example, the second insulation assembly 202 is a top insulation layer, as shown in FIG. 20.

In some embodiments, the second insulation assembly 202 includes a laminated structure with a same material. For example, the material of the laminated structure is at least one of a graphite felt, zirconia, alumina, a carbon material, or a carbon fiber material. By disposing the laminated structure, a thickness of the second insulation component changes with a count of layers of the laminated structure, so that the thickness of the second insulation component is adjusted according to an actual temperature field distribution, which is convenient for the insulation device to maintain a good and stable insulation effect, and at the same time saves the production costs. For example, when there is a need to increase the thickness of the second insulation assembly 202, the count of layers of the laminated structure is increased to realize the increase in the thickness. In some embodiments, when the thickness of the second insulation assembly 202 needs to be reduced, the thickness is reduced by decreasing the count of layers of the laminated structure.

In some embodiments, the count of layers of the laminated structure of the second insulation assembly 202 is in a range of 0-15. In some embodiments, the count of layers of the laminated structure of the second insulation assembly 202 is in a range of 0-10. In some embodiments, the count of layers of the laminated structure of the second insulation assembly 202 is in a range of 0-6.

In some embodiments, the second insulation assembly 202 includes a plurality of insulation sections. In some embodiments, the insulation sections of the second insulation assembly 202 are in an annular structure. Each of the insulation sections has a different diameter, and the plurality of insulation sections are stacked in a radial direction. In some embodiments, the adjacent insulation sections in the plurality of insulation sections are radially nested abut from each other to form the second insulation assembly 202. By disposing the plurality of insulation sections distributed in the radial direction, a thickness (e.g., a count of layers) is set individually for each insulation section to regulate the radial temperature distribution within the crystal growth device 10. In some embodiments, a fineness of the regulation of the radial temperature distribution within the growth device 10 is increased by disposing the count of the insulation sections distributed along the radial direction. In some embodiments, the count of insulation sections distributed along the radial direction is in a range of 2-10. In some embodiments, the count of insulation sections distributed along the radial direction is in a range of 2-6. In some embodiments, the count of insulation sections distributed along the radial direction is in a range of 2-15.

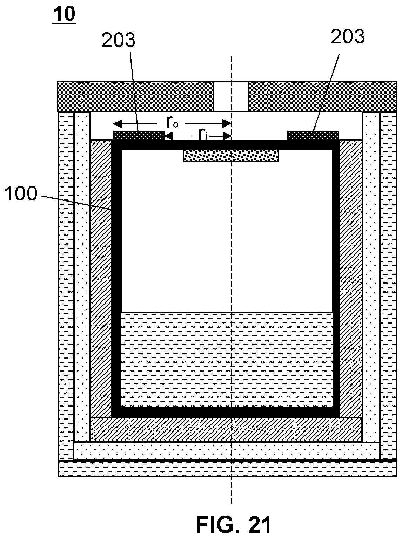

In some embodiments, the insulation device further includes a third insulation assembly 203. The second insulation assembly 202 is disposed on a top outer side of the crucible 100. For example, the third insulation assembly 203 is a pot top insulation layer, as shown in FIG. 21.

In some embodiments, the third insulation assembly 203 includes an annular structure or a circular structure. For example, a material of the third insulation assembly 203 includes one or more of a graphite felt, zirconia, alumina, a carbon material, or a carbon fiber material. In some embodiments, the insulation effect of the third insulation assembly 203 changes by disposing parameters of the annular structure. In some embodiments, the parameters of the annular structure include an inner diameter of the annular structure (also referred to as an inner radius), and an outer diameter of the annular structure (also referred to as an outer radius). As shown in FIG. 6, the inner diameter of the annular structure refers to a distance between the inner side of the annular structure and an axis of the crucible 100, and the outer diameter of the annular structure refers to a distance between the outer side of the annular structure and the axis of the crucible 100. By disposing the parameter of the annular structure, the insulation effect of the third insulation assembly changes with ranges of the inner and outer diameters of the annular structure, so that the insulation effect of the third insulation assembly may be adjusted according to a demand of the actual temperature field distribution, which facilitates the insulation device to maintain a good and stable insulation effect while saving the production cost. For example, a temperature of an edge region within the crucible 100 is increased by increasing the outer diameter of the annular structure, and a temperature of a center region within the crucible 100 is increased by decreasing the inner diameter of the annular structure.

In some embodiments, an inner diameter rᵢ of the annular structure is in a range of 10 mm-90 mm. In some embodiments, the inner diameter rᵢ of the annular structure is in a range of 30 mm-90 mm. In some embodiments, the inner diameter rᵢ of the annular structure is in a range of 30 mm-60 mm. In some embodiments, the inner diameter rᵢ of the ring structure is in a range of 60 mm-90 mm.

In some embodiments, an outer diameter rₒ of the annular structure is in a range of 90 mm-200 mm. In some embodiments, the outer diameter rₒ of the annular structure is in a range of 90 mm-150 mm. In some embodiments, the outer diameter rₒ of the annular structure is in a range of 90 mm-120 mm.

In some embodiments, the outer diameter rₒ of the annular structure is related to a size of the crucible 100. In some embodiments, a ratio of the outer diameter rₒ of the annular structure to a radius of the crucible 100 is in a range of 0.6-1.2. In some embodiments, the ratio of the outer diameter rₒ of the annular structure to the radius of the crucible 100 is in a range of 0.8-1.2. In some embodiments, the ratio of the outer diameter rₒ of the annular structure to the radius of the crucible 100 is in a range of 0.6-1. In some embodiments, the ratio of the outer diameter rₒ of the annular structure to the radius of the crucible 100 is in a range of 0.6-0.8.

In some embodiments, the ratio of the inner diameter rᵢ to the outer diameter rₒ of the annular structure is in a range of 0.1-0.8. In some embodiments, the ratio of the inner diameter rᵢ to the outer diameter rₒ of the annular structure is in a range of 0.3-0.8. In some embodiments, the ratio of the inner diameter rᵢ to the outer diameter rₒ of the annular structure is in a range of 0.5 to 0.8.

In some embodiments, the ratio of the inner diameter of the annular structure to the radius of the crucible 100 is in a range of 0.1-0.9. In some embodiments, the ratio of the inner diameter of the annular structure to the radius of the crucible 100 is in a range of 0.1-0.8. In some embodiments, the ratio of the inner diameter of the annular structure to the radius of the crucible 100 is in a range of 0.3-0.8.

The basic concepts have been described above, and it is apparent to those skilled in the art that the foregoing detailed disclosure serves only as an example and does not constitute a limitation of the present disclosure. Although not explicitly stated here, those skilled in the art may make various modifications, improvements and amendments to the present disclosure. These alterations, improvements, and modifications are intended to be suggested by the present disclosure, and are within the spirit and scope of the exemplary embodiments of the present disclosure.

Moreover, certain terminology has been used to describe embodiments of the present disclosure. As in "an embodiment", "one embodiment", or " some embodiments" means a feature, structure, or characteristic associated with at least one embodiment of the present disclosure. Accordingly, it should be emphasized and noted that two or more references to "an embodiment" or "one embodiment" in different positions in the present disclosure are not intended to be used to indicate the same embodiment. In addition, some features, structures, or characteristics in the one or more embodiments of the present disclosure may be appropriately combined.

Similarly, it should be appreciated that in the foregoing description of embodiments of the present disclosure, various features are sometimes grouped together in a single embodiment, figure, or description thereof for the purpose of streamlining the disclosure and aiding in the understanding of one or more of the various embodiments. However, the present disclosure does not mean that the object requires more features than the features mentioned in the claims. Rather, claimed subject matter may lie in less than all features of a single foregoing disclosed embodiment.

At last, it should be understood that the embodiments described in the present disclosure are merely illustrative of the principles of the embodiments of the present disclosure. Other modifications that may be employed are within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

## Claims

1. A crystal growth device, comprising:
a crucible including a raw material cavity for placing raw material and a growth cavity for crystal growth; and
at least one insulation device disposed on at least one side surface outside the crucible.

2. The crystal growth device of claim 1, wherein the crucible includes an upper cover including a cover body and a seed crystal tray, the seed crystal tray being detachably connected to the cover body.

3. The crystal growth device of claim 2, wherein the seed crystal tray includes a connecting structure disposed in a center region of a side of the seed crystal tray close to the cover body.

4. The crystal growth device of claim 2, wherein a thickness of the seed crystal tray is in a range of 2 mm-10 mm.

5. The crystal growth device of claim 2, wherein two surfaces of the seed crystal tray that are in contact with the cover body include a concave structure and a convex structure that cooperate with each other.

6. The crystal growth device of claim 2, wherein the seed crystal tray includes a separation groove for separating seed crystals on the seed crystal tray.

7. The crystal growth device of claim 6, wherein the separation groove is a circumferential groove disposed at a periphery of a side of the seed crystal tray away from the cover body.

8. The crystal growth device of claim 7, wherein a ratio of a depth of the circumferential groove along a radial direction to a radius of the seed crystal tray is in a range of 0.028-0.042.

9. The crystal growth device of claim 7, wherein a depth of the circumferential groove along a radial direction is in a range of 2 mm-4 mm, and a height of the circumferential groove along an axial direction is in a range of 0.5 mm-1.5 mm.

10. The crystal growth device of claim 1, wherein the crucible includes a guiding device disposed between the raw material cavity and the growth cavity, the guiding device including a first guiding surface inclined toward a bottom surface of the raw material cavity.

11. The crystal growth device of claim 10, wherein the guiding device includes a guiding groove, the guiding groove being a concave groove disposed at an outer periphery of the guiding device.

12. The crystal growth device of claim 11, wherein the guiding groove includes a second guiding surface parallel or substantially parallel to the first guiding surface, and a guiding wall is formed between the first guiding surface and the second guiding surface.

13. The crystal growth device of claim 12, wherein the guiding device further includes a support wall which is radially connected to the guiding wall and to an outer peripheral wall of the crucible.

14. The crystal growth device of claim 12, wherein a thickness of the guiding wall is in a range of 10 mm-60 mm.

15. The crystal growth device of claim 12, wherein a height of the guiding groove is in a range of 20 mm-40 mm.

16. The crystal growth device of claim 12, wherein a ratio of a thickness of the guiding wall to a height of the guiding groove is in a range of 0.2-1.5.

17. The crystal growth device of claim 13, wherein a thickness of the support wall is in a range of 10 mm-60 mm.

18. The crystal growth device of claim 13, wherein a ratio of a thickness of the guiding wall to a thickness of the support wall is in a range of 0.8-1.2.

19. The crystal growth device of claim 1, further comprising a furnace cavity and a temperature measurement structure, wherein the crucible is disposed in the furnace cavity, the temperature measurement structure includes a temperature measurement cavity and a temperature measurement window, the temperature measurement cavity includes a first cavity section, a main body portion, and a second cavity section, the temperature measurement window is disposed in the first cavity section, and the second cavity section is connected to the furnace cavity.

20. The crystal growth device of claim 19, wherein a diameter of the main body portion is less than a diameter of the furnace cavity.

21. The crystal growth device of claim 19, wherein a diameter of the first cavity section or a diameter of the second cavity section is less than a diameter of the main body portion.

22. The crystal growth device of claim 19, wherein the temperature measurement structure further includes an air inlet and an air outlet, the air inlet being interconnected with the first cavity section, and the air outlet being interconnected with the second cavity section.

23. The crystal growth device of claim 22, wherein a diameter of the air outlet is less than a diameter of the air inlet.

24. The crystal growth device of claim 19, wherein the temperature measurement structure further includes a cooler disposed in the second cavity section.

25. The crystal growth device of claim 19, wherein the temperature measurement structure further includes a deposition cavity connected to the furnace cavity.

26. The crystal growth device of claim 25, wherein a temperature within the deposition cavity is lower than a temperature within the furnace cavity.

27. The crystal growth device of claim 19, wherein the temperature measurement structure further includes a deposition cavity connected to the second cavity section.

28. The crystal growth device of claim 27, wherein a temperature within the deposition cavity is lower than both a temperature within the furnace cavity and a temperature within the temperature measurement cavity, and a pressure within the deposition cavity is lower than a pressure within the temperature measurement cavity.

29. The crystal growth device of claim 1, wherein the at least one insulation device includes a first insulation assembly, and the first insulation assembly includes:
an inner layer with a thickness that satisfies a preset condition;
an outer layer, wherein a material of the outer layer is different from a material of the inner layer; and
a middle layer disposed between the inner layer and the outer layer.

30. The crystal growth device of claim 29, wherein the first insulation assembly is at least disposed on a circumferential side of the crucible.

31. The crystal growth device of claim 29, wherein the thickness of the inner layer is in a range of 4 mm-57 mm.

32. The crystal growth device of claim 29, wherein a thickness of the middle layer is in a range of 28 mm-143 mm.

33. The crystal growth device of claim 29, wherein a thickness of the middle layer is greater than both the thickness of the inner layer and a thickness of the outer layer.

34. The crystal growth device of claim 29, wherein a ratio of the thickness of the inner layer to a thickness of the middle layer is in a range of 1:2-1:10.

35. The crystal growth device of claim 29, wherein a ratio of a thickness of the middle layer to a thickness of the outer layer is in a range of 2:0.5-10:3.

36. The crystal growth device of claim 29, wherein a ratio of the thickness of the inner layer to a thickness of the outer layer is in a range of 1:0.5-1:3.

37. The crystal growth device of claim 30, wherein the inner layer includes at least two insulation sections stacked top and down.

38. The crystal growth device of claim 30, wherein the inner layer varies in the thickness along an axial direction.

39. The crystal growth device of claim 29, wherein the material of the inner layer includes a graphite felt.

40. The crystal growth device of claim 29, wherein the material of the outer layer includes at least one of zirconia, alumina, a carbon material, or a carbon fiber material.

41. The crystal growth device of claim 29, wherein graphite paper is filled between the middle layer and the outer layer.

42. The crystal growth device of claim 29, wherein the insulation device further includes a second insulation assembly disposed on a top of the crystal growth device.

43. The crystal growth device of claim 42, wherein the second insulation assembly includes a laminated structure with a same material.

44. The crystal growth device of claim 42, wherein the insulation device further includes a third insulation assembly, the third insulation assembly including an annular structure or a circular structure.

45. The crystal growth device of claim 44, wherein an inner diameter of the annular structure is in a range of 10 mm-90 mm.

46. The crystal growth device of claim 44, wherein a ratio of an outer diameter of the annular structure to a radius of the crucible is in a range of 0.6-1.2.

47. The crystal growth device of claim 44, wherein a ratio of an inner diameter of the annular structure to an outer diameter of the annular structure is in a range of 0.1-0.8.

48. The crystal growth device of claim 44, wherein a ratio of an inner diameter of the annular structure to a radius of the crucible is in a range of 0.1-0.9.
